# EUROPÄISCHE PATENTSCHRIFT

(11) **EP 4 449 494 B1**
(45) Veröffentlichungstag und Bekanntmachung des Hinweises auf die Patenterteilung: **11.02.2026**
(21) Anmeldenummer: 22835378.5
(22) Anmeldetag: 13.12.2022
(51) Int. Cl.: H01L 23/373, H01L 23/473, H01S 5/024, C04B 37/02, C04B 35/645, H01L 23/467

(54) **TRÄGERSUBSTRAT FÜR ELEKTRISCHE BAUTEILE UND VERFAHREN ZUR HERSTELLUNG EINES SOLCHEN TRÄGERSUBSTRATS**
CARRIER SUBSTRATE FOR ELECTRICAL COMPONENTS, AND METHOD FOR PRODUCING SUCH A CARRIER SUBSTRATE
SUBSTRAT DE SUPPORT POUR COMPOSANTS ÉLECTRIQUES ET PROCÉDÉ DE PRODUCTION D'UN TEL SUBSTRAT DE SUPPORT

(30) Priorität: 14.12.2021 DE 102021132945
(43) Veröffentlichungstag der Anmeldung: 23.10.2024
(73) Patentinhaber: Rogers Germany GmbH, 92676 Eschenbach (DE)
(72) Erfinder: GIL, Vitalij, 91217 Hersbruck (DE); WIESEND, Johannes, 91281 Kirchenthumbach (DE); WAGLE, Fabian, 95447 Bayreuth (DE)
(74) Vertreter: Müller Schupfner & Partner Patent- und Rechtsanwaltspartnerschaft mbB (Muc)
(86) Internationale Anmeldenummer: PCT/EP2022/085608
(87) Internationale Veröffentlichungsnummer: WO 2023/110861

(56) Entgegenhaltungen:
- DE-A1- 102018 104 521
- DE-A1- 102018 112 000
- DE-A1- 102019 118 835
- DE-A1- 102020 104 493
- DE-A1- 102020 111 700
- US-A1- 2020 027 815

## Beschreibung

Die vorliegende Erfindung betrifft ein Trägersubstrat für elektrische Bauteile und ein Verfahren zur Herstellung eines solchen Trägersubstrats.

Aus dem Stand der Technik sind Kühlkörper zum Kühlen von elektrischen bzw. elektronischen Bauteilen, insbesondere Halbleitern, wie z. B. Laserdioden, hinlänglich bekannt. Dabei entwickeln die elektrischen bzw. elektronischen Bauteile während ihres Betriebs Wärme, die mittels des Kühlkörpers abgeführt wird, um so wiederum eine dauerhafte Funktionalität der elektrischen bzw. elektronischen Bauteile zu gewährleisten. Dies trifft insbesondere für Laserdioden zu, bei denen bereits Temperaturunterschiede von wenigen °C zu signifikanten Beeinträchtigungen der Leistung und/oder Lebensdauer führen können.

Zum Kühlen der Bauteile weisen die Kühlkörper, die in der Regel an die Bauteile angebunden sind, typischerweise ein Kühlfluidkanalsystem auf, durch das im Betrieb ein Kühlfluid geleitet wird, um vom elektrischen bzw. elektronischen Bauteil ausgehende Wärme aufzunehmen und abzutransportieren. Vorzugsweise wird hierbei eine Finnenstruktur verwendet, bei der mehrere stegartige Elemente in das Kühlfluidkanalsystem hineinragen, um eine möglichst große Kontaktfläche zum Kühlfluid bereitzustellen, wodurch die Wärmeübertragung von Wandungen, die das Kühlfluidkanalsystem begrenzen bzw. dort hineinragen, auf das Kühlfluid verbessert wird. Beispielsweise dienen die Kühlkörper dem Kühlen von Laserdioden.

Außerdem ist es üblich, Kühlkörper zum Kühlen von Leiterplatten zu verwenden, die als Metall-Keramik-Substrate ausgebildet sind.

Zur Isolation der elektrischen Bauteile an der Bauteilseite sind in die Trägersubstrate, in die die Kühlkörper integriert sind, typischerweise Isolationselemente eingelassen, wobei sich Keramikelemente wegen ihrer hohen Isolationsfestigkeit als besonders günstig erwiesen haben. Allerdings ist die Materialwahl für die zur elektrischen Isolation dienenden Keramikelemente durch das Herstellungsverfahren der Trägersubstrate, insbesondere durch das Anbinden des Kühlkörpers, beschränkt, sodass man beispielweise nicht die positiven thermischen Eigenschaften eines Si₃N₄-Substrats für solche Trägersubstrate nutzen kann.

Die DE 10 2020 111 700 A1 betrifft ein Metall-Keramik-Substrat mit einer Bindungsschicht, deren Haftvermittlerschicht einen Flächenwiderstand aufweist, der größer ist als 5 Ohm/sq. Die US 2020 027 815 A1 beschäftigt sich mit Wärmesenken für Leistungsmodule

Die vorliegende Erfindung macht es sich daher zur Aufgabe, verbesserte Trägersubstrate bereitzustellen, die, insbesondere durch ihre verbesserte Materialauswahl bezüglich des Keramikelements, einen optimierten Wärmeabtransport erzielen können.

Diese Aufgabe wird gelöst durch ein Trägersubstrat gemäß Anspruch 1 und ein Verfahren gemäß Anspruch 9. Weitere Ausbildung und Ausführungsformen sind den Unteransprüchen, der Beschreibung und den Figuren zu entnehmen.

Gemäß einem ersten Aspekt der vorliegenden Erfindung ist ein Trägersubstrat für elektrische Bauteile vorgesehen, das folgendes aufweist:
- einen Kühlkörper, und
- ein Keramikelement, wobei das Keramikelement zumindest abschnittsweise an den Kühlkörper angebunden ist,

wobei im gefertigten Trägersubstrat eine lötmaterialfreie Bindungsschicht zwischen dem Kühlkörper und dem Keramikelement ausgebildet ist, und
wobei eine Haftvermittlerschicht der Bindungsschicht einen Flächenwiderstand aufweist, der größer ist als 5 Ohm/sq, bevorzugt größer als 10 Ohm/sq und besonders bevorzugt größer als 20 Ohm/sq.

Im Gegensatz zu den aus dem Stand der Technik bekannten Trägersubstraten, die einen Kühlkörper und ein Keramikelement aufweisen, ist es erfindungsgemäß vorgesehen, dass eine zwischen Keramikelement und Kühlkörper ausgebildete lötmaterialfreie Bindungsschicht vorgesehen ist, die einen vergleichsweise hohen Flächenwiderstand aufweist. Mit anderen Worten: Das Anbindungsverfahren, das zur Anbindung an das Keramikelement verwendet wurde, hat auf ein Lotmaterial verzichtet und das Herstellungsverfahren hat auch dazu geführt, dass ein vergleichsweise großer Flächenwiderstand erzeugt wurde. Dies ist insbesondere dann der Fall, wenn die Anbindung an das Keramikelement über ein heißisostatisches Pressen erfolgt, bevorzugt ein heißisostatisches Pressen, bei dem eine Aktivmetallschicht zwischen Keramikelement und der anzubindenden Metallschicht angeordnet ist. Dadurch entsteht eine, insbesondere im Wesentlichen durch die Haftvermittlerschicht bestimmte bzw. festgelegte Bindungsschicht mit einer homogen verteilten, vergleichsweise geringen (entlang einer Stapelrichtung bemessenen) Dicke.

Unter einer lötmaterialfreien Bindungsschicht ist insbesondere eine solche Bindungsschicht zu verstehen, die im Wesentlichen bzw. ausschließlich auf Aktivmetall zurückzuführen ist und keine zusätzlichen Bestandteile aufweist, die auf ein Lotbasismaterial oder eine aktivmetallhaltiges Lötmaterial zurückzuführen sind. Mit anderen Worten: Bevorzugt wird die Bindungsschicht im Wesentlichen ausschließlich durch die Haftvermittlerschicht gebildet. Dabei wird durch den Anbindungsprozess eine verwendete Aktivmetallschicht zur Bindungsschicht bzw. ein Teil der Bindungsschicht.

Zusammen mit weiteren Parametern, wie beispielsweise der Reinheit der aufgetragenen Aktivmetallschicht und/oder der Rauheit des Keramikelements, trägt dies zu einem entsprechend ausgebildeten Flächenwiderstand bei. Der Verzicht auf ein Lotmaterial bei der Anbindung der Metallschicht an das Keramikelement (,was wiederum zu den anspruchsgemäßen Eigenschaften führt) hat den Vorteil, dass im Rahmen des Anbindungsprozesses des Kühlkörpers die hierbei erforderlichen Temperaturen nicht die Bindung zwischen Metallschicht und Keramikelement beeinträchtigen. Dabei erfolgt die Anbindung des Kühlkörpers in einem an die Anbindung der Metallschicht an das Keramikelement anschließenden Folgeschritt, bei dem Temperaturen herrschen, die im Falle der Anbindung über eine Lotmaterial das Lotmaterial wieder schmelzen lassen würden. Im Gegensatz zu aus Lotmaterial hervorgegangenen Bindungsschichten, d. h. lotmaterialhaltige Bindungsschichten, erweisen sich solche Bindungsschichten, die den anspruchsgemäßen Flächenwiderstand aufweisen als standhaft gegenüber den Temperaturen, die beim Anbinden des Kühlkörpers an das Metall-Keramik-Substrat vorliegen. Dadurch ist es wiederum in vorteilhafter Weise möglich, auch solche Trägersubstrate bereitzustellen, deren Keramikelemente vorher ungeeignet waren, weil sie ausschließlich über ein Lotsystem an eine Metallschicht angebunden werden konnten, insbesondere solche Lotsysteme, die nicht den Temperaturen standhalten, die notwendig sind für die Anbindung des Kühlkörpers.

Es wird dabei darauf hingewiesen, dass die beschriebene Bindungsschicht zwischen dem Kühlkörper und dem Keramikelement angeordnet ist und insbesondere an der Kühlseite des Keramikelements ausgebildet ist bzw. an diese angrenzt. Insbesondere wird betont, dass aufgrund des Herstellungsverfahrens zwischen dem Kühlkörper (in der Form, in der dieser dem Anbindungsverfahren bereitgestellte wird) und dem Keramikelement, bzw. zwischen dem Kühlkörper, der verbaut worden ist, und dem Keramikelement, in Stapelrichtung gesehen mindestens ein Metallabschnitt ausgebildet sein kann. Sofern dieser Metallabschnitt aus demselben Material wie der Kühlkörper gefertigt ist, der im Herstellungsverfahren herangezogen worden ist, kann es zu einem fließenden Übergang zwischen Kühlkörper und diesem Metallabschnitt kommen. Der Fachmann wird daher entweder diesen Metallabschnitt, der dem ursprünglich herangezogenen Kühlkörper nicht zuzuschreiben ist, aber im gefertigten Zustand einstückig mit dem bereitgestellten Kühlkörper verbunden ist, entweder dem Kühlkörper im gefertigten Zustand zuschreiben oder erkennen, dass auch eine weitere Metallschicht oder ein weiterer Metallabschnitt zwischen Kühlkörper und Trägersubstrat ausgebildet sein kann.

Das Trägersubstrat kann beispielsweise eine Leiterplatte sein, bei der an dessen Bauteilseite, Leiterbahnen und/oder Anschlussflächen ausgebildet sind, die zur Anbindung von elektrischen Bauteilen vorgesehen sind, insbesondere zur Ausbildung von elektrischen Schaltkreisen. Alternativ ist es vorstellbar, dass es sich bei dem Trägersubstrat um ein Kühlsystem handelt, mit dem beispielsweise eine Laserdiode oder eine Laserdiodenanordnung gekühlt werden kann. Vorzugsweise ist es dabei vorgesehen, dass der Kühlkörper hervorgeht aus einem Aufeinanderstapeln mindestens einer ersten und zweiten Metallschicht, die wiederum durch ein Direktanbindungsverfahren miteinander verbunden werden bzw. sind. Durch entsprechende Ausnehmungen innerhalb der ersten Metallschicht und der zweiten Metallschicht kann ein Kühlkanalsystem erzeugt werden, durch das im Betrieb ein Kühlfluid, beispielsweise eine Kühlflüssigkeit oder ein Kühlgas, geführt werden kann, um Wärme vom Trägersubstrat abzuführen. Es ist auch vorstellbar, dass der Kühlkörper anders hergestellt wurde und/oder beispielsweise eine Finnenstruktur bereitstellt. Unabhängig von der Form des Bereitstellens, kann es sich um eine offene oder um eine geschlossene Kühlstruktur im Kühlkörper handeln.

Zur Bestimmung des Flächenwiderstands ist es vorgesehen, dass am gefertigten Trägersubstrat zunächst die Metallschicht und ggf. eine Lotbasisschicht, beispielsweise durch Ätzen, wieder entfernt werden. Mittels einer Vier-Punkt Messung wird dann an der Oberseite bzw. Unterseite des von der mindestens einen Metallschicht und der Lotbasisschicht befreiten Trägersubstrats ein Flächenwiderstand gemessen. Insbesondere ist unter dem Flächenwiderstand einer Materialprobe als dessen Widerstand bezogen auf einen quadratischen Oberflächenbereich zu verstehen. Es ist hierbei üblich den Oberflächenwiderstand mit der Einheit Ohm/sq(square) zu kennzeichnen. Die Physikalische Einheit des Flächenwiderstandes ist Ohm.

Vorzugsweise ist das Trägersubstrat als Leiterplatte ausgebildet, bei der im gefertigten Zustand die mindestens eine Metallschicht, die an das Keramikelement angebunden ist, strukturiert ist. Beispielsweise ist es hierzu vorgesehen, dass nach dem Anbindungsschritt auch eine Strukturierung, beispielsweise durch Lasern, Ätzen und/oder eine mechanische Bearbeitung, vorgenommen wird, mit der Leiterbahnen und/oder Anschlüsse für elektrische oder elektronische Bauteile realisiert werden. Vorzugsweise ist es vorgesehen, dass an einem gefertigten Metall-Keramik-Substrat an dem Keramikelement, an dem der Metallschicht gegenüberliegenden Seite, eine weitere Metallschicht, insbesondere eine Rückseitenmetallisierung vorgesehen ist. Dabei dient die Rückseitenmetallisierung vorzugsweise dazu, einer Durchbiegung entgegenzuwirken und der Kühlkörper, der wiederum an die Rückseitenmetallisierung angebunden wird, dient einem wirkungsvollen Abführen von Wärme, die im Betrieb von elektrischen bzw. elektronischen Bauteilen ausgeht, die an die Leiterplatte, bzw. das Metall-Keramik-Substrat angebunden sind.

Als Materialien für die Metallschicht im Metall-Keramik-Substrat oder für das Metall des Kühlkörpers sind Kupfer, Aluminium, Molybdän, Wolfram, Nickel und/oder deren Legierungen wie z. B. CuZr, AlSi oder AlMgSi, sowie Laminate wie CuW, CuMo, CuAl und/oder AlCu oder MMC (metal matrix composite), wie CuW, CuM oder AlSiC, vorstellbar. Weiterhin ist bevorzugt vorgesehen, dass die mindestens eine Metallschicht am gefertigten Metall-Keramik-Substrat, insbesondere als Bauteilmetallisierung, oberflächenmodifiziert ist. Als Oberflächenmodifikation ist beispielsweise eine Versiegelung mit einem Edelmetall, insbesondere Silber; und/oder Gold, oder (electroless) Nickel oder ENIG (*"electroless nickel immersion gold"*) oder ein Kantenverguss an der Metallisierung zur Unterdrückung einer Rissbildung bzw. -weitung denkbar.

Vorzugsweise ist es vorgesehen, dass eine in Stapelrichtung bemessene Dicke der Bindungsschicht bzw. Haftvermittlerschicht, gemittelt über mehrere Messpunkte innerhalb einer vorbestimmten Fläche oder in mehreren Flächen, die parallel zur Haupterstreckungsebene verläuft oder verlaufen, einen Wert annimmt, der kleiner als 1000 nm, bevorzugt kleiner als 600 nm und besonders bevorzugt kleiner als 350 nm ist. Sofern vom mehreren Flächen gesprochen wird, ist insbesondere gemeint, dass die Metallschicht in möglichst gleich große Flächen unterteilt wird und in jeder dieser die Metallschicht unterteilenden Flächen mindestens ein Wert, bevorzugt mehrere Messwerte, für die Dicke erfasst werden. Die so an verschiedenen Stellen ermittelten Dicken werden arithmetisch gemittelt Insbesondere weist das Keramikelement eine nicht über ein Direktanbindungsverfahren anbindbare Materialzusammensetzung auf. Vorzugsweise ist es vorgesehen, dass das Keramikelement Siliziumnitrid umfasst. Insbesondere ist es vorgesehen, dass das Keramikelement zu mehr als 60 Gew.-%, bevorzugt mehr als 80 Gew.-% und besonders bevorzugt mehr als 90 Gew.-% Siliziumnitrid umfasst. Siliziumnitrid erweist sich insbesondere deswegen als vorteilhaft, weil es zu einer hohen Temperaturwechselbeständigkeit führt und eine hohe Biegebruchfestigkeit bereitstellt. Außerdem wird aufgrund des erhöhten thermischen Expansionskoeffizienten die Ausbildung von thermomechanischen Spannungen reduziert. Hinzukommt, dass eine verbesserte thermische Leitfähigkeit die Effizienz beim Abführen von Wärme verbessern kann. Dabei erweist es sich als besonders vorteilhaft, dass durch das herangezogene heißisostatische Pressen bei der Herstellung des Metall-Keramik-Substrats, gerade auch Siliziumnitrid für solche Trägersubstrate verwendet werden kann. Schließlich lässt sich Siliziumnitrid nicht in einem Direktanbindungsverfahren an eine Metallschicht, insbesondere eine Kupferschicht, anbinden und die erforderlichen Lötmaterialien weisen eine Schmelztemperatur von unterhalb 1000 °C auf, sodass diese bei einem Direktanbindungsverfahren des Kühlkörpers das Lötmaterial wieder aufschmelzen würden. Somit ermöglicht das Verfahren, das sich strukturell in der lotfreien Bindungsschicht mit dem erhöhten Flächenwiederstand niederschlägt, auch die Nutzung von Siliziumnitrid in einem entsprechenden Trägersubstrat. Weiterhin ist es bevorzugt vorgesehen, dass das Keramikelement, insbesondere die Siliziumnitridkeramik, eine thermische Leitfähigkeit aufweist, die größer ist als 90 W/mK, bevorzugt größer als 110 W/mK und besonders bevorzugt größer als 120 W/mK. Darüber hinaus ist es vorstellbar, dass das Keramikelement eine Dicke aufweist, die kleiner ist als 300 µm, bevorzugt kleiner als 250 µm und besonders bevorzugt kleiner als 200 µm.

Alternativ weist das Keramikelement Al₂O₃, AIN, eine HPSX-Keramik (d. h. eine Keramik mit einer Al₂O₃- Matrix, die einen x-prozentigen Anteil an ZrO₂ umfasst, beispielsweise Al₂O₃ mit 9% ZrO₂ = HPS9 oder Al₂O₃ mit 25% ZrO₂ = HPS25), SiC, BeO, MgO, hochdichtes MgO (> 90% der theoretischen Dichte), TSZ (tetragonal stabilisiertes Zirkonoxid) als Material für die Keramik auf. Es ist dabei auch vorstellbar, dass das Keramikelement als Verbund- bzw. Hybridkeramik ausgebildet ist, bei der zur Kombination verschiedener gewünschter Eigenschaften mehrere Keramikschichten, die sich jeweils in Hinblick auf ihre materielle Zusammensetzung unterscheiden, übereinander angeordnet und zu einem Keramikelement zusammengefügt sind. Vorzugsweise ist das Keramikelement frei von Parylene.

Erfindungsgemäß ist es vorgesehen, dass der Kühlkörper über eine Rückseitenmetallisierung an das Keramikelement angebunden ist und die Haftvermittlerschicht zwischen Rückseitenmetallisierung und Keramikelement ausgebildet ist. Die dem Kühlkörper zuzuordnende Rückseitenmetallisierung ist in einem vorbereitenden Herstellungsschritt an das Keramikelement gebunden und der Kühlkörper wird erst im Anschluss an die Anbindung der Rückseitenmetallisierung angebunden. Dadurch sind der Rückseitenmetallisierungsabschnitt und der Kühlkörper unterschiedlichen Temperaturbehandlungen unterworfen, die sich in unterschiedlichen Körnungen niederschlagen. Folglich kann man diese Abschnitte am gefertigten Substrat erkennen.

Vorzugsweise ist es vorgesehen, dass sich eine Körnung in der Rückseitenmetallisierung von einer Körnung im Kühlkörper unterscheidet. Da sich im Fertigungsprozess die Rückseitenmetallisierung beim heißsostatischen Pressen auch dadurch erzielen lässt, dass die anzubindenden Metalllage in einem Metallbeutel fixiert ist und dies dazu führt, dass Metalllage und ein Teil des Metallbeutels angebunden werden, lassen sich auch strukturelle Unterschiede erkennen, wenn Metallmaterialen unterschiedlicher Reinheit für die Metalllage und den Metallbeutel verwendet werden.

Beispielsweise enthält die Bindungsschicht zwischen Rückseitenmetallisierung und Keramikelement einen Aktivmetallanteil, der auf eine Aktivmetallschicht zurückzuführen ist, die im Fertigungsprozess herangezogen wird.

Weiterhin ist es vorstellbar, dass die Rückseitenmetallisierung entlang einer Haupterstreckungsebene gegenüber dem Kühlkörper vorsteht. Da der Kühlkörper an die Rückseitenmetallisierung, die bereits am Keramikelement angebunden ist, angebunden wird und vorzugsweise sich nicht über die gesamte Rückseite des Keramikelements erstreckt, kann man die Rückseitenmetallisierung größer gestalten. Dadurch muss die vorzugsweise vollflächige an das Keramikelement angebundene Rückseitenmetallisierung nicht wieder partiell entfernt werden. Außerdem wird dadurch in der Fertigung das Positionieren des Kühlkörpers gegenüber der Rückseitenmetallisierung vereinfacht, da nicht eine absolut deckungsgleiche Anordnung erforderlich ist.

Vorzugsweise ist es vorgesehen, dass der Kühlkörper vorzugsweise mindestens aus einer ersten Metallschicht und einer zweiten Metallschicht ausgebildet ist, die übereinander mittels eines Direktanbindungsverfahren, insbesondere ein lotfreies Direktanbindungsverfahren, verbunden sind, wobei die erste Metallschicht und/oder die zweite Metallschicht Aussparungen aufweisen, die im gefertigten Trägersubstrat einen Kühlkanal formen. Dabei ist es ferner vorstellbar, dass der Kühlkanal bis zum Keramikelement reicht und/oder zwischen Keramikelement und Kühlkanal fast ausschließlich und, bevorzugt ausnahmslos, eine Restmetallschichtdicke vorgesehen ist. Für die Ausbildung eines bis zum Trägersubstrat, bzw. bis zum Keramikelement reichenden Kühlkanals ist es dabei vorgesehen, dass im Fertigungsprozess, nach dem Anbinden einer Rückseitenmetallisierung an das Keramikelement, die Rückseitenmetallisierung strukturiert wird, um entsprechende Bereiche am Keramikelement freizulegen, bevor der Anbindungsprozess des Kühlkörpers an die Rückseitenmetallisierung erfolgt.

Vorzugsweise ist ein Abstand von einen Kühlkanal begrenzenden Seitenflächen kleiner als 0,5 mm, bevorzugt kleiner als 0,4 mm und besonders bevorzugt kleiner als 0,3 mm. Insbesondere sind solche Seitenflächen gemeint, die in einer parallel zur Haupterstreckungsebene verlaufenden Richtung zueinander beabstandet sind. Solche vergleichsweise dünnen Kanäle und Abstände zwischen Seitenflächen, lassen sich beispielsweise durch ein Erodieren bzw. ein Drahterodieren in den jeweiligen Metallschichten erzeugen. Solche dünnen Kühlkanäle erweisen sich insbesondere deswegen als vorteilhaft, weil sie eine hohe Effizienz bei der Übertragung der Wärme gewährleisten und zudem auch eine möglichst flächige und homogen verteilten Kühl- bzw. Wärmeübertrag an der Kühlseite bereitstellen können.

Vorzugsweise ist es vorgesehen, dass eine in Stapelrichtung bemessene Dicke der Bindungsschicht bzw. der Haftvermittlerschicht, gemittelt über mehrere Messpunkte innerhalb einer vorbestimmten Fläche oder in mehreren Flächen, die parallel zur Haupterstreckungsebene verläuft oder verlaufen, einen Wert annimmt, der kleiner als 1000 nm, bevorzugt kleiner als 600 nm und besonders bevorzugt kleiner als 350 nm ist. Sofern vom mehreren Flächen gesprochen wird, ist insbesondere gemeint, dass die Metallschicht in möglichst gleich große Flächen unterteilt wird und in jeder dieser die mindestens eine Metallschicht unterteilenden Flächen mindestens ein Wert, bevorzugt mehrere Messwerte, für die Dicke erfasst werden. Die so an verschiedenen Stellen ermittelten Dicken werden arithmetisch gemittelt.

Gegenüber den aus dem Stand der Technik bekannten Trägersubstraten ist somit eine vergleichsweise dünne Bindungsschicht zwischen der mindestens einen Metallschicht und dem Keramikelement ausgebildet. Dabei ist es vorgesehen, dass zur Festlegung der maßgeblichen Dicke der Bindungsschicht die gemessenen Dicken über eine Vielzahl von Messpunkten gemittelt werden, die innerhalb einer vorbestimmten bzw. festgelegten Fläche bzw. den mehreren Flächen liegen.

Insbesondere ist es vorgesehen, dass die ein Aktivmetall umfassende Haftvermittlerschicht eine im Wesentlichen konstante Dicke aufweist. Insbesondere weisen die innerhalb der Fläche oder den Flächen bestimmten Messwerte der Dicke eine Verteilung auf, der eine Standardabweichung zuzuordnen ist, die kleiner ist als 0,2 µm, bevorzugt kleiner als 0,1 µm und besonders bevorzugt kleiner als 0,05 µm. Insbesondere das physikalische und/oder chemische Gasphasenabscheiden einer Aktivmetallschicht und die sich daraus ergebenden Bindungsschicht gestatten es, eine homogene und gleichmäßig verteilte Dicke der Bindungsschicht zu erzielen, die insbesondere nur aus der Haftvermittlerschicht besteht. Die Haftvermittlerschicht kann dabei auch eine konstante Dicke aufweisen, wenn sie zusätzlich zum Lotbasismaterial ausgebildet ist.

Ein weiterer Gegenstand der vorliegenden Erfindung ist ein Verfahren zur Herstellung eines erfindungsgemäßen Substrats umfassend: Anbinden einer Rückseitenmetallisierung und vorzugsweise der Bauteilmetallisierung an ein Keramikelement zur Bildung eines Metall-Keramik-Substrats mittels heißisostatischen Pressen,
- Bereitstellen eines Kühlkörpers, insbesondere eines Kühlkörpers mit einer Kühlkanalstruktur, und
- Anbinden des Kühlkörpers an die Rückseitenmetallisierung mittels eines Direktanbindungsverfahrens, insbesondere eines DCB-Verfahrens.

Alle beschriebenen Vorteile und Eigenschaften des Trägersubstrats lassen sich analog anwenden und übertragen auf das Verfahren und andersrum.

Vorzugsweise ist es vorgesehen, dass bei einem heißisostatischen Pressen der Metallbehälter bzw. eine Metallschicht in einer Heiz- und Druckvorrichtung einem Gasdruck zwischen 100 und 2000 bar, bevorzugt zwischen 150 und 1200 bar und besonders bevorzugt zwischen 300 und 1000 bar und einer Prozesstemperatur von 300 °C bis zu einer Schmelztemperatur einer Metallschicht, insbesondere bis zu einer Temperatur unterhalt der Schmelztemperatur, ausgesetzt wird. Es hat sich in vorteilhafter Weise herausgestellt, dass es so möglich ist, eine Metallschicht, beispielsweise die Bauteilmetallisierung und/oder Rückseitenmetallisierung, an das Keramikelement anzubinden, ohne die erforderlichen Temperaturen eines Direktmetallanbindungsverfahrens, beispielsweise eines DCB- oder einem DAB-Verfahrens, und ohne ein Lotbasismaterial oder Lotmaterial, das beim Aktivlöten verwendet wird. Darüber hinaus gestattet das Nutzen bzw. die Verwendung eines entsprechenden Gasdrucks die Möglichkeit, möglichst lunkerfrei, d. h. ohne Gaseinschlüsse zwischen Metallschicht und Keramikelement ein Metall-Keramik-Substrat zu fertigen. Insbesondere finden Prozessparameter Verwendung, die in der DE 2013 113 734 A1 erwähnt werden und auf die hiermit explizit Bezug genommen wird. Außerdem hat sich herausgestellt, dass die auf diese Weise hergestellte Verbindung zwischen Keramikelement und Metallschicht auch Temperaturen standhält, die größer sind als 1050 °C.

Insbesondere zeichnet sich das vorliegende Verfahren dadurch aus, dass die Anbindung der Rückseitenmetallisierung an das Keramikelement im Rahmen eines heißisostatischen Pressens erfolgt und nicht im Rahmen eines Lötverfahrens. Dadurch wird die Bindung zwischen Bauteilmetallisierung bzw. Rückseitenmetallisierung auf der einen Seite und dem Keramikelement auf der anderen Seite widerstandfähiger, insbesondere widerstandsfähiger im Hinblick auf Temperaturen, die verwendet werden bei der Anbindung des Kühlkörpers an das Metall-Keramik-Substrat. Insbesondere ist es dabei vorgesehen, dass der Kühlkörper an die Rückseitenmetallisierung des, durch heißisostatisches Pressen erzeugten, Metall-Keramik-Substrats angebunden wird. Infolgedessen ist man nicht mehr auf lotbasierte Bindungsverfahren angewiesen, um solche Keramikelemente zu verwenden, die sich nicht über ein Direktanbindungsverfahren an eine Metallschicht anbinden lassen. Daher ermöglicht das beschriebene Verfahren auch die Anbindung von solchen Keramikelementen, die vorher nicht für die Bildung von beschriebenen Trägersubstraten herangezogen werden konnten, da die verwendeten Lotmaterialien andernfalls im Anbindungsprozess des Kühlkörpers beschädigt oder sogar zerstört werden würden.

Vorzugsweise ist es vorgesehen, dass eine Ausnehmung in einer ersten Metallschicht oder einer zweiten Metallschicht mittels Ätzen, Erodieren und/oder Fräsen realisiert wird und mindestens die erste und zweite Metallschicht zur Bildung des Kühlkörpers miteinander verbunden werden. Dadurch wird der Kühlkörper für die Anbindung bereitgestellt, wobei der entsprechende Kühlkörper ein Kühlkanalsystem bereitstellt, über das ein Kühlfluid geführt werden kann, um die Wärme im gefertigten Trägersubstrat abzuführen.

Vorzugsweise ist es vorgesehen, dass eine Aktivmetallschicht zwischen dem Keramikelement und der Bauteilmetallisierung bzw. der Rückseitenmetallisierung andererseits angeordnet wird. Dadurch wird eine besonders starke Verbindung beim heißisostatischen Pressen zwischen Rückseitenmetallisierung und Keramikelement bereitgestellt, wobei die Aktivmetallschicht wesentlich zur Ausbildung der Haftvermittlerschicht, bzw. der Bindungsschicht beiträgt. Dabei ist es insbesondere vorgesehen, dass die Aktivmetallschicht nach dem Fertigungsprozess zu der Haftvermittlerschicht, insbesondere der Bindungsschicht wird.

Insbesondere ist es durch die Nutzung einer separat ausgeführten Aktivmetallschicht möglich, diese vergleichsweise dünn auszugestalten, wodurch die anspruchsgemäßen vergleichsweise dünnen Dicken der Bindungsschicht realisierbar sind, insbesondere gemittelt über verschiedenen Messerwerte innerhalb der festgelegten Fläche bzw. Flächen. Beispiele für ein Aktivmetall sind Titan (Ti), Zirkonium (Zr), Hafnium (Hf), Chrom (Cr), Niob (Nb), Cer (Ce), Tantal (Ta), Magnesium (Mg), Lanthan (La) und Vanadium (V). Hierbei ist darauf zu achten, dass die Metalle La, Ce, Ca und Mg leicht oxidieren können. Ferner wird angemerkt, dass die Elemente Cr, Mo und W keine klassischen Aktivmetalle sind, sich aber als Kontaktschicht zwischen Si₃N₄ und der mindestens einem Metallschicht bzw. dem Lotsystem bzw. Lotmaterial eignen, da sie mit der mindestens einen Metallschicht, beispielsweise Kupfer, keine intermetallischen Phasen bilden und keine Randlöslichkeit haben.

Vorzugsweise wird das Aktivmetall mittels eines chemischen und/oder physikalischen Gasphasenabscheidens, beispielsweise mittels eines Sputterns, auf dem Lotbasismaterial und/oder der mindestens einen Metallschicht und/oder dem Keramikelement aufgetragen, um vergleichsweise dünne Aktivmetallschichten zu realisieren, die wiederrum zu einer vergleichsweise dünnen Bindungsschicht führen, insbesondere zu einer homogenen und dünnen Haftvermittlerschicht. Vorstellbar ist es auch unter Verwendung eines Plasmas, in einem Vakuum und/oder mittels Aufdampfen die Aktivmetallschicht auf dem Keramikelement und/oder der Metallschicht für Bauteilmetallisierung und/oder Rückseitenmetallisierung bereitzustellen. Denkbar ist auch, die Aktivmetallschicht galvanisch zu realisieren. Besonders bevorzugt ist es vorgesehen, dass die Aktivmetallschicht als Folie bereitgestellt wird.

Dabei lässt sich die Aktivmetallschicht insbesondere durch ein gasphysikalisches Abscheiden bereitstellen, wodurch vergleichsweise dünne Aktivmetallschichten realisiert werden können, die ebenfalls dazu beitragen können, dass der anspruchsgemäße Flächenwiederstand realisiert wird. Vorstellbar ist auch ein galvanisches, ein stromloses und/oder ein thermisches Auftragen bzw. ein Auftragen mittels Kaltgasspritzen.

Vorzugsweise ist es vorgesehen, dass ein Verhältnis zwischen einer Dicke der Aktivmetallschicht zu einer Dicke der ersten Metallschicht und/oder zweiten Metallschicht einen Wert zwischen 0,0001 und 0,005, bevorzugt zwischen 0,005 und 0,003 und besonders bevorzugt 0,001 und 0,0015 annimmt. In entsprechender Weise ist eine vergleichsweise dünne Aktivmetallschicht von Vorteil, um eine wirkungsvolle Bindungsschicht zu realisieren und dabei den Verbrauch von Aktivmetall begrenzt zu halten.

Vorzugsweise ist es vorgesehen, dass das Anbinden des Kühlkörpers an die Rückseitenmetallisierung nach dem Ausbilden des Metall-Keramik-Substrats durch heißisostatisches Pressen realisiert wird. Dabei wird zunächst das Metall-Keramik-Substrat ausgebildet, um beim Ausbildungsprozess des Metall-Keramik-Substrats durch möglich gleiche bzw. vergleichbare Dicken der Rückseitenmetallisierung und der Bauteilmetallisierung dafür zu sorgen, dass ein Durchbiegen aufgrund thermomechanischer Spannungen im Metall-Keramik-Substrat verhindert wird. Mit anderen Worten, es wird zunächst ein Metall-Keramik-Substrat mit Bauteilmetallisierung und Rückseitenmetallisierung hergestellt, um zu verhindern, dass nach dem oder während dem Anbindungsprozess ein Durchbiegen des Metall-Keramik-Substrats erfolgt, was das Resultat der unterschiedlichen thermomechanischen Ausdehnungskoeffizienten von Keramikelement und Metallschicht wäre. An ein solches im Wesentlichen ebenes und flaches Metall-Keramik-Substrat lässt sich dann einfacher ein Kühlkörper insbesondere über dessen Deckschicht anbinden. Andernfalls wäre das Metall-Keramik-Substrat aufwändig geradezubiegen, sofern dies noch möglich ist. Außerdem hat es sich gezeigt, dass bei Metallschichten, die größer als 0,4 mm sind und die an das Keramikelement angebunden werden, größere thermomechanische Spannungen nach dem Abkühlen verursacht werden, die nach dem Abkühlen auch weiterhin bestehen bleiben.

Weitere Vorteile und Eigenschaften ergeben sich aus der nachfolgenden Beschreibung bevorzugter Ausführungsformen des erfindungsgemäßen Gegenstands mit Bezug auf die beigefügten Figuren. Es zeigt:
- **Fig. 1**: schematische Darstellung eines Trägersubstrats gemäß einer beispielhaften Ausführungsform der vorliegenden Erfindung
- **Fig. 2:**: schematische Explosionsdarstellung eines Trägersubstrats für eine beispielhafte Ausführungsform der vorliegenden Erfindung,
- **Fig.3**: schematische Darstellung einer ersten Metallschicht für ein Kühlkörper aus Figur 1,
- **Fig. 4**: schematische Darstellung eines Trägersubstrats für eine weitere beispielhafte Ausführungsform der vorliegenden Erfindung,
- **Fig. 5 bis Fig. 8:**: detaillierte Darstellung des Systems aus dem Trägersubstrat mit einer Verteilstruktur

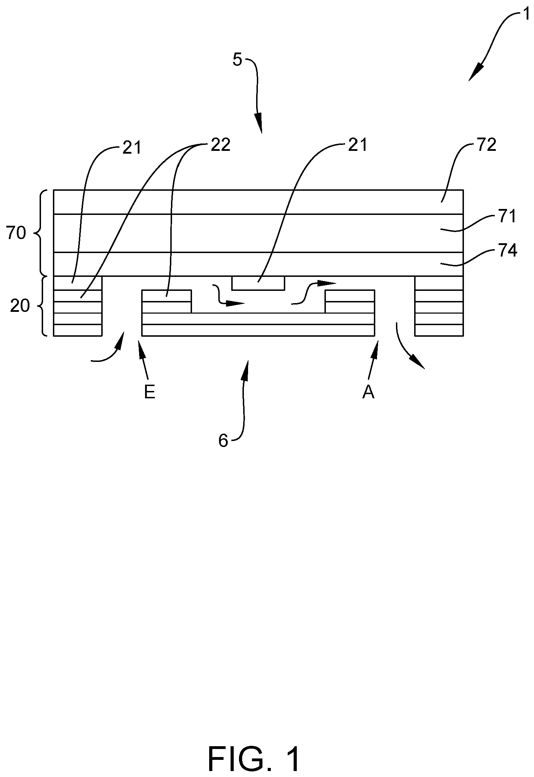

In **Figur 1** ist schematisch ein Trägersubstrat 1 gemäß einer bevorzugten Ausführungsform der vorliegenden Erfindung dargestellt. Solche Trägersubstrate 1 sind insbesondere dazu vorgesehen, dass elektrische Bauteile 4 an ihrer Bauteilseite 5 angebunden werden können. Dabei kann es sich beispielsweise bei dem Trägersubstrat 1 um eine Leiterplatte handeln, bei der mehrere Anschlussflächen und Leiterbahnen und Kontaktbereiche vorgesehen sind, über die Schaltkreise realisiert werden. Es ist auch vorstellbar, dass es sich bei dem Trägersubstrat 1 im Wesentlichen um eine Kühlstruktur handelt, die dazu vorgesehen ist, gezielt eine elektrische Komponente, wie eine Laserdiode bzw. eine Laserdiodenanordnung, zu kühlen. Um die im Betrieb entstehende Wärme der elektrischen Bauteile 4 abzuführen, umfasst das Trägersubstrat 1 einen Kühlkörper 20. Dieser Kühlkörper 20 ist auf einer, der Bauteilseite 5 gegenüberliegenden, Kühlseite 6 ausgebildet. Vorzugsweise handelt es sich bei dem Kühlkörper 20 um eine metallische Struktur, die durch Aufeinanderstapeln mindestens einer ersten Metallschicht 21 und einer zweiten Metallschicht 22 und durch anschließendes Verbinden der mindestens einen Metallschicht 21 und der zweiten Metallschicht 22 entstanden ist. Durch Aussparungen, die in die erste Metallschicht 21 und/oder zweite Metallschicht 22 eingelassen sind, ist es möglich ein Kanalsystem innerhalb des Kühlkörpers 20 zu realisieren. Durch dieses Kanalsystem kann ein Kühlfluid, beispielsweise ein Kühlgas oder eine Kühlflüssigkeit, geführt werden, um entsprechend Wärme von dem Trägersubstrat 1 abzuführen. Zur Isolation der elektrischen Bauteile 4, insbesondere vom metallischen Kühlkörper 20, umfasst das Trägersubstrat 1 ein Keramikelement 71. Vorzugsweise ist es vorgesehen, dass das Trägersubstrat 1 eine Metall-Keramik-Substrat 70 und den Kühlkörper 20 umfasst, die zur Ausbildung des Trägersubstrats 1 miteinander verbunden sind. Dabei ist es vorzugsweise vorgesehen, dass das Metall-Keramik-Substrat 70 eine Bauteilmetallisierung 72 an der Bauteilseite des Keramikelements 71 vorsieht und eine Rückseitenmetallisierung 74 an einer der Bauteilseite 5 gegenüberliegenden Kühlseite 6 eines Keramikelements 71 des Metall-Keramik-Substrats 70. Dabei entsprechen sich die Dicken der Bauteilmetallisierung 72 und der Rückseitenmetallisierung 74, um insbesondere im Fertigungsschritt, bei dem eine Anbindung der Bauteilmetallisierung 72 bzw. der Rückseitenmetallisierung 74 an das Keramikelement 71 erfolgt, thermomechanische Spannungen kompensieren zu können, die aufgrund der unterschiedlichen thermischen Ausdehnungskoeffizienten von Rückseitenmetallisierung 74 / Bauteilmetallisierung 72 auf der einen Seite und Keramikelement 71 auf der anderen Seite veranlasst werden. Ohne eine solche Kompensation neigt das Metall-Keramik-Substrat 70 zur Durchbiegung. Daher ist es vorzugsweise vorgesehen, dass der Kühlkörper 20 an das Metall-Keramik-Substrat 70, insbesondere an die Rückseitenmetallisierung 74 des bereits gefertigten Metall-Keramik-Substrats 71 angebunden wird. Die Anbindung einer Deckseite des Kühlkörpers 20 an die Rückseitenmetallisierung 74 erfolgt dabei vorzugsweise durch ein Direktanbindungsverfahren, insbesondere durch ein lotfreies Direktanbindungsverfahren, das Temperaturen oberhalb von 1.068 °C erforderlich macht, um ein Eutektikum zu erzeugen, das zwischen der Rückseitenmetallisierung 74 und der Deckschicht des Kühlkörpers 20 entsteht. Im dargestellten Ausführungsbeispiel bildet die erste Metallschicht 21 die Deckschicht aus.

Vorzugsweise ist es dabei vorgesehen, dass beim Anbindungsprozess des Kühlkörpers 20 an das Metall-Keramik-Substrat 1 bereits die erste Metallschicht 21 und die zweite Metallschicht 22 miteinander verbunden sind. Alternativ ist es vorstellbar, dass zeitgleich oder mindestens zeitlich überlappend die Anbindung zwischen der ersten Metallschicht 21 und der zweiten Metallschicht 22 und die Anbindung zwischen der Deckschicht des Kühlkörpers 20 und der Rückseitenmetallisierung 74 durchgeführt werden. Dabei ist es vorstellbar, dass die erste Metallschicht 21 die Deckschicht bildet (siehe Ausführungsbeispiel der Figur 1) und/oder die Deckschicht eine zusätzliche Schicht ist, die an eine Oberseite des Kühlkörpers 20 angebunden ist. Beispielsweise es vorstellbar, dass die Deckschicht eine durchgehende Metallschicht ohne Ausnehmungen bildet.

Die Notwendigkeit, den Kühlkörper 20 mittels eines Direktanbindungsverfahrens und daher mit den entsprechenden Temperaturen an das Metall-Keramik-Substrat 1, insbesondere an die Rückseitenmetallisierung 74, anzubinden, hat zur Konsequenz, dass auch die bereits erzeugte Bindung zwischen dem Keramikelement 71 und der Bauteilmetallisierung 72 bzw. der Rückseitenmetallisierung 74 den Herstellungsbedingungen für die Anbindung des Kühlkörpers 20 an das Metall-Keramik-Substrat 1 standhalten muss. Andernfalls würden die verwendeten Herstellungsbedingung, die im Rahmen des Anbindens des Kühlkörpers 20 an das Metall-Keramik-Substrat 70 erforderlich sind, die Bindung zwischen Rückseitenmetallisierung 74 bzw. Bauteilmetallisierung 72 und Keramikelement 71 wieder lösen oder zumindest beeinträchtigen. Dies ist insbesondere dann der Fall, wenn zur Anbindung der Bauteilmetallisierung 72 bzw. der Rückseitenmetallisierung 74 an das Keramikelement 71, Lotmaterialien verwendet werden müssen, deren Schmelztemperatur unterhalb von 1000 °C liegen.

Dies hat allerdings auch zur Folge, dass solche Keramikelemente 71 von der Nutzung in den beschriebenen Trägersubstraten 1 ausgeschlossen werden, die ausschließlich über ein Lotmaterial an eine Metallschicht (d. h. an Bauteilmetallisierung 72 bzw. Rückseitenmetallisierung 74)angebunden werden können. Dies trifft beispielsweise auf Siliziumnitrid zu, das nicht im Rahmen eines Direktanbindungsverfahrens an ein Metall angebunden werden kann. Um auch solche Keramikelemente in den beschriebenen Trägersubstraten zu verwenden, die andernfalls ausgeschlossen werden müssten, sieht es die vorliegende Erfindung vor, die Anbindung der Bauteilmetallisierung bzw. der Rückseitenmetallisierung, an das Keramikelement durch ein lotfreies Anbindungsverfahren, insbesondere ein lotfreies, heißisostatisches Pressen, an das Keramikelement 71 anzubinden.

Insbesondere ist es dabei vorgesehen, dass im Rahmen des Anbindungsprozesses zwischen dem Keramikelement 71 und der Bauteilmetallisierung 72 und/oder zwischen dem Keramikelement 71 und der Rückseitenmetallisierung 74 während des heißisostatischen Pressens eine Aktivmetallschicht angeordnet ist. Diese wird beispielsweise vor dem heißisostatischen Pressen auf der Bauteilseite 5 bzw. der Kühlseite 6 des Keramikelements 71 und oder auf die Bauteilmetallisierung 72 und/oder Rückseitenmetallisierung 74 aufgetragen, beispielsweise durch ein gasphysikalisches Abscheideverfahren, beispielsweise durch ein Sputterprozess, oder ein elektrochemisches Verfahren. Es hat sich dadurch herausgestellt, dass eine Bindung zwischen Keramikelement 71 und Bauteilmetallisierung 72 bzw. Rückseitenmetallisierung 74 möglich ist, insbesondere auch für solche Keramikelemente 71, die nicht zugänglich sind für ein Direktmetallanbindungsverfahren. Gleichzeitig hat es sich herausgestallt, dass die Verbindung auch den Temperaturen standhält, die bei dem Direktanbindungsverfahren des Kühlkörpers 20 an das Metall-Keramik-Substrat 70 erforderlich sind. Dies liegt insbesondere daran, dass die Anbindung zwischen Keramikelement und Metallschicht in diesem Fall ohne Lotmaterial bzw. Lotbasismaterial erfolgen kann.

Dabei wird noch einmal herausgestellt, dass die Aktivmetallschicht eine Aktivmetallschicht, deren Anteil an Aktivmetall größer ist als 15 Gew.-%, bevorzugt größer als 30 Gew.-% und besonders bevorzugt größer als 70 Gew.-%. Es handelt sich somit nicht um eine aktivmetallhaltige Lotschicht, wie sie andernfalls üblich ist, bei der Anbindung einer Bauteilmetallisierung 72 an ein Keramikelement 71. Dadurch kann man beispielsweise auf solche Keramikelemente 71 zurückgreifen, die aufgrund ihrer hohen thermischen Leitfähigkeit besonders günstig sind oder vorteilhaft zur Ausbildung eines entsprechenden Trägersubstrates 1. Dies trifft insbesondere für solche Trägersubstrate 1 zu, deren Keramikelement 71 Siliziumnitride umfasst, bzw. zu mehr als 80% aus Siliziumnitrid gebildet sind.

Das beschriebene Anbindungsverfahren zeichnet sich vorzugsweise dadurch aus, dass die Bindungsschicht
- zwischen dem Keramikelement 71 und der Bauteilmetallisierung 72 und/oder zwischen Keramikelement 71 und Rückseitenmetallisierung 74 eine Bindungsschicht aufweist, deren Flächenwiderstand größer ist als 5 Ohm/sq, bevorzugt größer als 15 Ohm/sq und besonders bevorzugt größer als 20 Ohm/sq. Der beschriebene Flächenwiderstand ist dabei insbesondere Resultat einer gleichmäßig aufgetragenen Aktivmetallschicht und der Anbindung über ein heißisostatisches Pressen. Bindungsschichten, die unter Verwendung eines Lotmaterials mit Aktivmetallbestandteil erzeugt werden, weisen hingegen einen geringeren Flächenwiderstand auf. Insbesondere ist es vorgesehen, dass zwischen Rückseitenmetallisierung 74 bzw. Bauteilmetallisierung 72, und Keramikelement 71 als Bindungsschicht lediglich eine Haftvermittlerschicht ausgebildet ist, d. h. keine Teilbereiche zu identifizieren sind im gefertigten Trägersubstrat 1, die auf ein Lotmaterial zurückzuführen sind.

Da durch den Bindungsprozess der Rückseitenmetallisierung 74 an die Deckschicht des Kühlkörpers 20 im Rahmen eines Direktanbindungsverfahrens keine Grenzlinie/Übergangsbereich am gefertigten Übergang zwischen Rückseitenmetallisierung 74 und Oberseite des Kühlkörpers 20 zu erkennen ist, ist im gefertigten Zustand die Rückseitenmetallisierung 74 Teil des Kühlkörpers 20. Somit bildet sich der Flächenwiderstand zwischen Keramikelement 71 und Kühlkörper 20 aus, zu dem im gefertigten Zustand die ursprüngliche Rückseitenmetallisierung 74 des Metall-Keramik-Substrats 1 zuzurechnen ist. Somit sind die nach dem erfindungsgemäßen Verfahren hergestellten Metall-Keramik-Substrate dadurch zu erkennen, dass ein entsprechender Flächenwiderstand zwischen Keramikelement 71 und Kühlkörper 20 ausgebildet ist. Zudem ist es insbesondere vorgesehen, dass sich eine Bindungsschicht ausbildet, die ausschließlich als Haftvermittlerschicht ausgebildet ist, die nicht auf ein Lotmaterial zurückzuführen ist.

Weiterhin ist in Figur 1 ein mäander- bzw. schleifenförmigen Kanalsystem ausgebildet, in das beispielsweise über einen Eingang E ein Kühlfluid eingeführt werden kann, das in einer schleifen- oder mäanderförmigen Bewegung durch den Kühlkörper 20 geführt wird, um schließlich durch eine Auslassöffnung A den Kühlkörper 20 wieder zu verlassen. In den folgenden Figuren sind weiter Beispiele für Kühlkörper angeführt, die für bestimmte Ausführungsformen der Erfindung vorgesehen sein könnten und die an ein Metall-Keramik-Substrat 70, insbesondere dessen Rückseitenmetallisierung angebunden werden können.

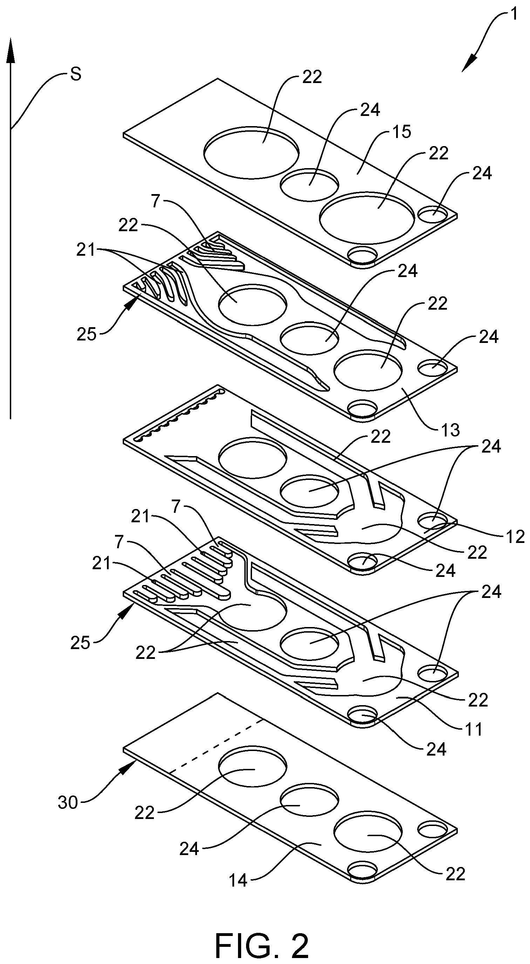

In **Figur 2** ist schematisch eine Explosionsdarstellung eines Kühlkörpers 1 gemäß einer ersten bevorzugten Ausführungsform für einen Gegenstand nach der vorliegenden Erfindung dargestellt. Insbesondere handelt es sich bei dem Kühlkörper 1 um ein solches, das zum Kühlen eines elektronischen oder elektrischen Bauteils (nicht dargestellt), insbesondere eines Halbleiterelements und besonders bevorzugt einer Laserdiode, vorgesehen ist. Zum Kühlen des elektrischen bzw. des elektronischen Bauteils bildet das gefertigte Kühlkörper 1 ein Kühlfluidkanalsystem aus, durch das im Betrieb ein Kühlfluid leitbar ist, so dass das Kühlfluid Wärme, die von dem elektronischen bzw. elektrischen Bauteil im Betrieb ausgeht, aufnehmen und wegführen kann.

Hierzu sind in dem Kühlkörper 1, insbesondere im Kühlfluidkanalsystem, vorzugsweise ein Zuleitungsbereich und ein Ableitungsbereich vorgesehen (nicht gezeigt), wobei über den Zuleitungsbereich das Kühlfluid eingeleitet wird und über den Ableitungsbereich wieder ausgeleitet wird. Vorzugsweise ist es vorgesehen, dass das Kühlfluidkanalsystem derart ausgestaltet ist, dass das Kühlfluid 1 beim Übergang vom Zuleitungsbereich zum Ableitungsbereich eine Finnenstruktur 25 passiert, die insbesondere in das Kühlfluidkanalsystem hineinragt. Bei der Finnenstruktur 25 handelt es sich vorzugsweise um stegartige Elemente 7 die in das Kühlfluidkanalsystem hineinragen, um eine möglichst große Kontaktfläche für das Fluid bereitzustellen, sodass eine wirkungsvolle Übertragung der Wärme vom stegartigem Element 7 bzw. der Wandung des Kühlkanalsystems auf das Fluid möglich ist.

Vorzugsweise umfasst das Kühlkörper 1 mindestens eine erste Metallschicht 11, mindestens eine zweite Metallschicht 12 und/oder mindestens eine dritte Metallschicht 13. Zur Ausbildung des Kühlfluidkanalsystems sind die mindestens eine erste Metallschicht 11, die mindestens zweite Metallschicht 12 und/oder die mindestens dritte Metallschicht 13 durch mindestens eine Ausnehmung 21, 22 derart strukturiert, dass sie durch ein Aufeinanderstapeln bzw. ein übereinanderlegen entlang der Stapelrichtung S das Kühlfluidkanalsystem ausbildet.

Dabei ist es insbesondere vorgesehen, dass die mindestens eine erste Metallschicht 11, die mindestens eine zweite Metallschicht 12 und/oder die mindestens eine dritte Metallschicht 13 jeweils anders strukturiert sind bzw. mit anders verlaufenden Ausnehmungen 21, 22 ausgestattet sind. Insbesondere ist es vorgesehen, dass die mindestens eine erste Metallschicht 11, die mindestens eine zweite Metallschicht 12 und/oder die mindestens eine dritte Metallschicht 13 mindestens einen ersten Teil 21 in der mindestens einen Ausnehmung 21, 22 ausformt, der die stegartigen Elemente 7 aufweist, die insbesondere sich in einer senkrecht zur Stapelrichtung S verlaufenden Haupterstreckungsebene HSE erstrecken. Neben dem ersten Teil 21 der mindestens einen Ausnehmung 21, 22 in der mindestens einen ersten Metallschicht 11 ist es vorzugsweise vorgesehen, dass ein zweiter Teil 22 der mindestens einen Ausnehmung 21, 22 in der mindestens einen ersten Metallschicht 11 für das Zuleiten oder Ableiten des Kühlfluides in den ersten Teil 21 bzw. aus dem ersten Teil 21 vorgesehen ist bzw. einen Teil des Zuleitungsbereich und/oder Ableitungsbereichs bildet.

Das Kühlkörper 1 wird vorzugsweise in Stapelrichtung S durch eine obere Deckschicht 15 und eine untere Deckschicht 14 begrenzt, wobei die erste mindestens eine erste Metallschicht 11, die mindestens eine zweite Metallschicht 12 und/oder die mindestens eine dritte Metallschicht 13 in Stapelrichtung S gesehen zwischen der unteren Deckschicht 14 und der oberen Deckschicht 15 angeordnet ist. Insbesondere ist die Formation aus der mindestens einen ersten Metallschicht 11, der mindestens einen zweiten Metallschicht 12 und/oder der mindestens einen dritten Metallschicht 13 sandwichartig zwischen der oberen Deckschicht 15 und der unteren Deckschicht 14 angeordnet. Neben der mindestens einen Ausnehmung 21, 22, die sich zusammensetzt aus dem ersten Teil 21 und dem zweiten Teil 22, ist es vorzugsweise vorgesehen, dass das Kühlkörper 1 bzw. die mindestens eine erste Metallschicht 11 eine weitere Ausnehmung 24 aufweist, die kein Bestandteil des Kühlfluidkanalsystems, mit der Finnenstruktur 25 ist. Weiterhin ist es vorzugsweise vorgesehen, dass an der oberen Deckschicht 15 und/oder der unteren Deckschicht 14 eine Anschlussfläche 30 vorgesehen ist. Insbesondere wird an dieser Anschlussfläche 30 das elektrische bzw. elektronische Bauteil angebunden, insbesondere in Stapelrichtung S gesehen, oberhalb bzw. unterhalb der Finnenstruktur 25, die sich vorzugsweise in einer senkrecht zur Stapelrichtung S verlaufenden Richtung erstreckt. Mit anderen Worten: die Finnenstruktur 25, insbesondere deren stegartigen Elemente 7, erstreckt sich unterhalb der Anschlussfläche 30 und vorzugsweise parallel dazu. Durch die entsprechende Anordnung der Finnenstruktur 25 aus den stegartigen Elementen 7 oberhalb bzw. unterhalb der Anschlussfläche 30 lässt sich das elektrische bzw. das elektronische Bauteil wirkungsvoll mittels der Finnenstruktur 25 kühlen.

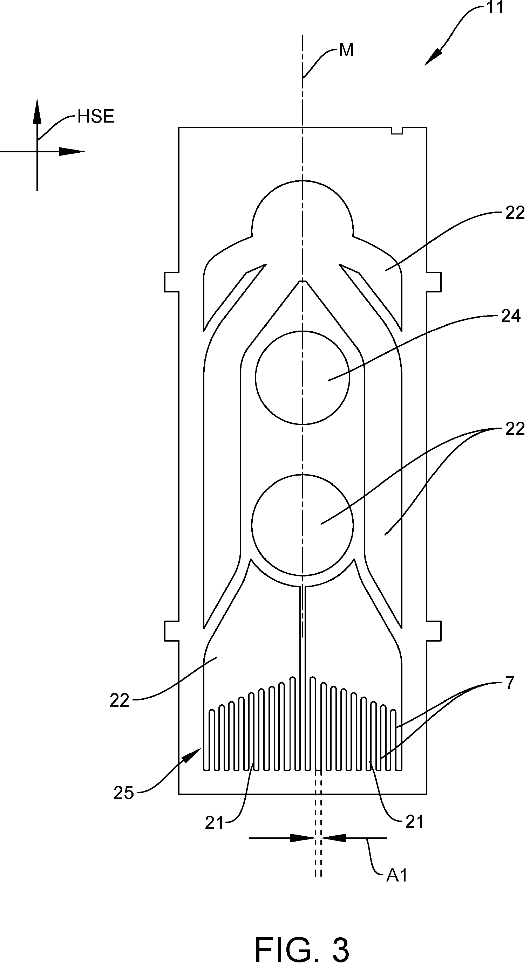

In **Figur 3**ist eine schematische Darstellung einer mindestens einen ersten Metallschicht 11 dargestellt, die beispielsweise in Figur 1 verbaut ist. In der dargestellten Ausführungsform ist die Finnenstruktur 25 aus stegartigen Elementen 7 ausgebildet, die sich in Haupterstreckungsebene HSE gesehen, unterschiedlich weit erstrecken. Insbesondere nimmt eine Länge der stegartigen Elemente 7 zu einer Mittelachse M der mindestens einen ersten Metallschicht 11 zu. Dadurch ist es in vorteilhafter Weise möglich, die Kühlwirkung insbesondere im Zentralbereich der Anschlussfläche 30 möglichst zu maximieren. Ferner ist es vorstellbar, dass die stegartigen Elemente parallel und/oder schräg zur Mittelachse M verlaufen. Vorzugsweise wird die Form der stegartigen Elemente 7 insbesondere deren Länge und/oder Neigung gegenüber der Mittelachse M entlang der Haupterstreckungsebene HSE durch das entsprechende Anforderungsprofil für das Kühlen des entsprechenden elektrischen oder elektronischen Bauteils bestimmt bzw. festgelegt.

Um einen möglichst geringen Abstand A1 zwischen zwei benachbarten stegartigen Elementen 7 zu erzielen, ist es beispielsweise vorgesehen, dass der erste Teil 21 der mindestens einen Ausnehmung 21, 22 in der mindestens einen ersten Metallschicht 11 durch ein Erodieren, insbesondere Funkenerodieren, erfolgt. Insbesondere handelt es sich dabei um ein Herstellen mittels Drahterodieren.

Ferner ist es vorgesehen, dass ein zweiter Teil 22 der mindestens einen Ausnehmung 21, 22 durch ein Ätzen erfolgt. Vorzugsweise wird das Ätzen insbesondere in großflächigen Bereichen des zweiten Teils 22 der Ausnehmung 21, 22 durchgeführt, d. h. in den späteren Zuführ- und/der Ableitbereichen, die für das Zuführen und das Ableiten des Kühlfluids ausgebildet sind. Im Gegensatz dazu ist es insbesondere vorgesehen, dass das Erodieren für die feinstrukturierte Ausformung der Ausnehmung 21, 22, d. h. den ersten Teil 21 der Ausnehmung 21, 22 vorgesehen ist. Es hat sich herausgestellt, dass dadurch vergleichsweise sehr geringe Abstände zwischen den stegartigen Elementen 7 hergestellt werden können, ohne dass man auf mehrere erste Metallschichten 11 mit geätzten ersten Teilen 21 der mindestens einen Ausnehmung 21, 22 angewiesen wäre, die übereinander gestapelt werden müssten, um einen möglichst geringen Abstand zwischen zwei stegartigen Elementen 7 zu realisieren. Vorzugsweise ist der Abstand A1 zwischen gegenüberliegenden Seitenwänden zwischen zwei stegartigen Elementen 7 kleiner als 0,4 mm, bevorzugt kleiner als 0,3 mm und besonders bevorzugt kleiner als 0,2 mm. Dadurch lassen sich möglichst viele stegartige Elemente 7 in die Finnenstruktur 25 integrieren. Entsprechend ist es möglich, die Kühlwirkung zu erhöhen, da die Kontaktfläche zwischen Kühlfluid und Wandlung des Kühlfluidkanalsystems in entsprechender Weise erhöht werden kann.

Vorzugsweise weisen die mindestens eine erste Metallschicht 11, die mindestens eine zweite Metallschicht 12, die mindestens eine dritte Metallschicht 13, die obere Deckschicht 15 und/oder die untere Deckschicht 14 eine in Stapelrichtung S gemessene Dicke zwischen 0,2 und 0,7 mm, bevorzugt zwischen 0,35 und 0,6 mm und besonders bevorzugt zwischen 0,3 und 0,4 mm auf. Vorzugsweise bilden die mindestens eine erste Metallschicht 11, die mindestens eine zweite Metallschicht 12 und/oder die mindestens eine dritte Metallschicht 13 jeweils dieselbe Dicke aus. Weiterhin ist es bevorzugt vorgesehen, dass die mindestens eine erste Metallschicht 11, die mindestens eine zweite Metallschicht 12 und/oder die mindestens eine dritte Metallschicht 13 im Rahmen eines Sinterverfahrens zu einem integralen Kühlfluidkanalsystem geformt werden, indem durch eine entsprechende Temperaturbehandlung die Gefüge der mindestens einen ersten Metallschicht 11, der mindestens einen zweiten Metallschicht 12 und/oder der mindestens einen dritten Metallschicht 13 ineinander übergehen bzw. miteinander verschmelzen. Weiterhin ist es vorgesehen, dass auch die obere Deckschicht 15 und/oder die untere Deckschicht 14 jeweils mindestens eine Ausnehmung 21, 22 und/oder eine weitere Ausnehmung 24 aufweisen, wobei die obere Deckschicht 15 und/oder die untere Deckschicht 14 vorzugsweise frei sind von stegartigen Elementen 7 bzw. Bestandteilen einer späteren Finnenstruktur 25. Die weiteren Ausnehmungen 24 dienen vorzugsweise der Befestigung oder Fixierung des Kühlkörpers 1.

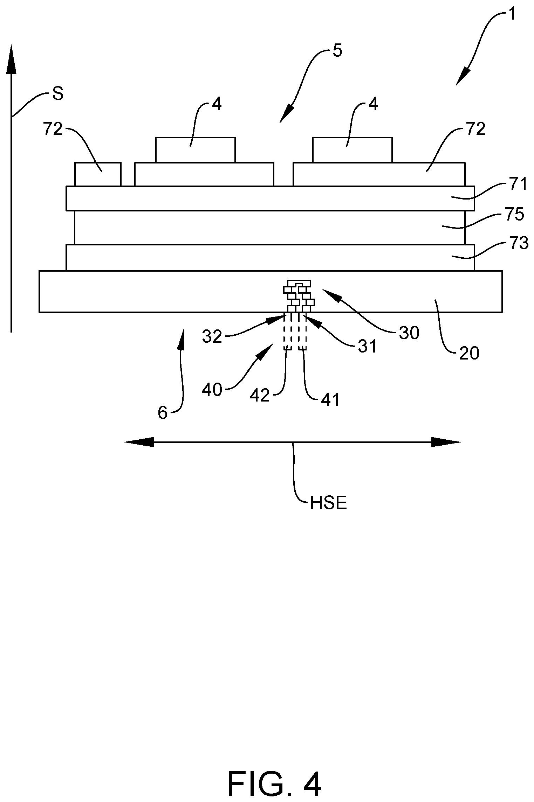

In **Figur 4** ist schematisch ein Metall-Keramik-Substrat 70 gemäß einer weiteren beispielhaften Ausführungsform der vorliegenden Erfindung dargestellt. Solche Metall-Keramik-Substrate 1 dienen vorzugsweise als Träger von elektronischen bzw. elektrischen Bauteile 4, die an das Metall-Keramik-Substrat 70 anbindbar sind. Wesentliche Bestandteile eines solchen Metall-Keramik-Substrats 1 sind eine sich entlang einer Haupterstreckungsebene HSE erstreckendes Keramikelement 71 und eine an der Keramikschicht 71 angebundene Bauteilmetallisierung 72. Das Keramikelement 71 ist aus mindestens einem eine Keramik umfassenden Material gefertigt. Die Bauteilmetallisierung 72 und das Keramikelement sind dabei entlang einer senkrecht zur Haupterstreckungsebene HSE verlaufenden Stapelrichtung S übereinander angeordnet und miteinander stoffschlüssig verbunden. Im gefertigten Zustand ist die Bauteilmetallisierung 72 auf einer Bauteilseite 5 des Metall-Keramik-Substrats 70 zur Bildung von Leiterbahnen oder Anbindungsstellen für die elektrischen Bauteile 4 strukturiert. In der dargestellten Ausführungsform umfasst das Metall-Keramik-Substrat 70 eine Sekundärschicht 73 und eine zwischen dem Keramikelement 71 und der Sekundärschicht 73 angeordnete metallische Zwischenschicht 75. Das Keramikelement 71, die metallische Zwischenschicht 75 und die Sekundärschicht 13 sind entlang der Stapelrichtung S übereinander angeordnet. Ferner ist es vorgesehen, dass die metallische Zwischenschicht 75 dicker ist als das Keramikelement 71 und/oder die Sekundärschicht 73. Vorzugsweise ist die metallische Zwischenschicht 75 dicker als 1 mm, bevorzugt dicker als 1,5 mm und besonders bevorzugt dicker als 2,5 mm. Es ist aber auch vorstellbar, dass zur Ausbildung des Metall-Keramik-Substrats lediglich ein Keramikelement 71 mit einer Bauteilmetallisierung 72 und einer Rückseitenmetallisierung ausgebildet ist. Während das Keramikelement 71 bevorzugt aus Keramik ist und zur Ausbildung einer ausreichenden Isolationsfestigkeit und zur Versteifung des Metall-Keramik-Substrats 1 ausgelegt ist, kann die Sekundärschicht 73 beispielsweise auch aus Wolfram oder Molybdän sein, da hier keine ausgeprägte Isolationsfestigkeit erforderlich ist. So lassen sich die Materialkosten senken. Alternativ ist die Sekundärschicht 73 ebenfalls aus einem eine Keramik umfassenden Material gefertigt.

Auf einer der Bauteilseite 5 gegenüberliegenden Kühlseite 6 des Metall-Keramik Substrats 1 ist ein metallischer Kühlkörper 20 vorgesehen. Der metallische Kühlkörper 20 ist vorzugsweise unmittelbar an die Sekundärschicht 73 angebunden. Es ist aber auch vorstellbar, dass der Kühlkörper 20 direkt an eine Rückseitenmetallisierung des Metall-Keramik-Substrats 1 oder an das Keramikelement 71 des Metall-Keramik-Substrats 1 angebunden ist. Dadurch lässt sich vermeiden, dass eine sich andernfalls ausbildende Grenzfläche mit einem entsprechenden Verbindungsmaterial negativ auf die Wärmleitfähigkeit und somit einschränkend auf einen Wärmeabtransport von der Bauteilseite 5 zur Kühlseite 6 auswirkt.

Beispielsweise ist die Kühlstruktur 20 über ein AMB-Verfahren, ein DCB (direct copper bonding)- oder DAB (direct aluminium bonding)- Verfahren unmittelbar an die Sekundärschicht 73, die Rückseitenmetallisierung und/oder an das Keramikelement 71 angebunden. Insbesondere ist es vorgesehen, dass in die metallische Kühlstruktur 20 eine Vielzahl von Fluidkanälen 30 integriert ist. Der Übersicht halber ist in Figur 1 beispielhaft nur ein einzelner dieser Fluidkanäle 30 eingezeichnet. Die Fluidkanäle 30 dienen einer gezielten Führung eines Fluids, insbesondere eines Kühlfluids, innerhalb der metallischen Kühlstruktur 20. Der Kühlstruktur 20 wird das Fluid über ein Verteilstruktur 40 zugeführt und über die Verteilstruktur 40 wieder abgeführt. Vorzugsweise weist die Verteilstruktur 40 hierzu einen einleitenden Teil 41 und einen ableitenden Teil 42 auf.

Insbesondere weist der Fluidkanal 30 eine Eingangsöffnung 31 und eine von der Eingangsöffnung 31 beabstandete Ausgangsöffnung 32 auf. Dabei sind die Eingangsöffnung 31 und die Ausgangsöffnung 32 Teil einer der Verteilstruktur 40 zugewandten Außenseite A der Kühlstruktur 20. Insbesondere grenzt der einleitende Teil 31 der Verteilstruktur 40 an die Eingangsöffnung 31 und der ableitenden Teil 42 an die Ausgangsöffnung 32 an.

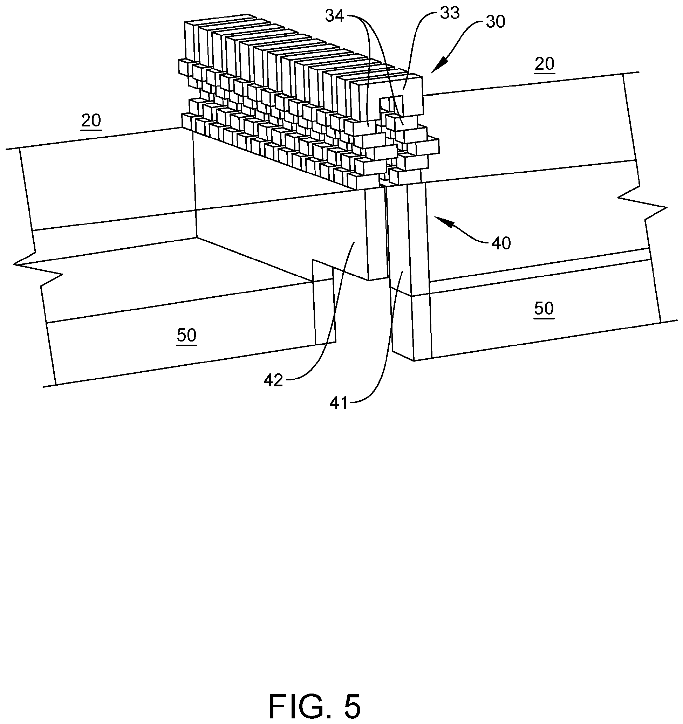

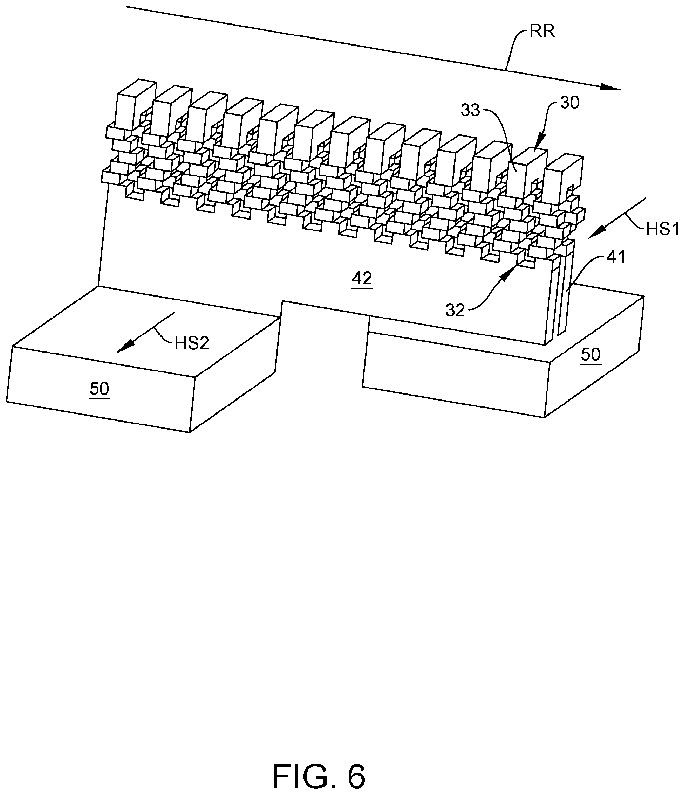

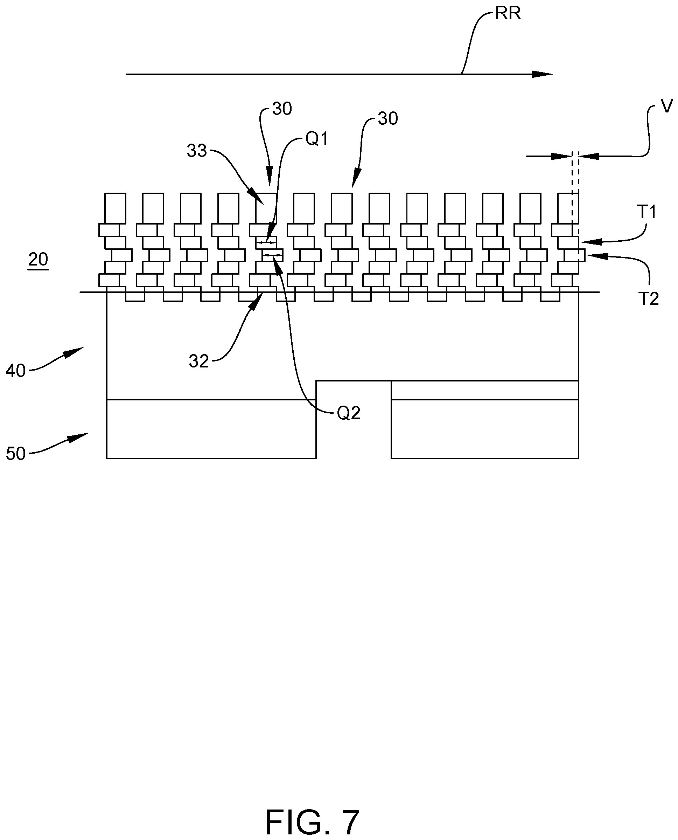

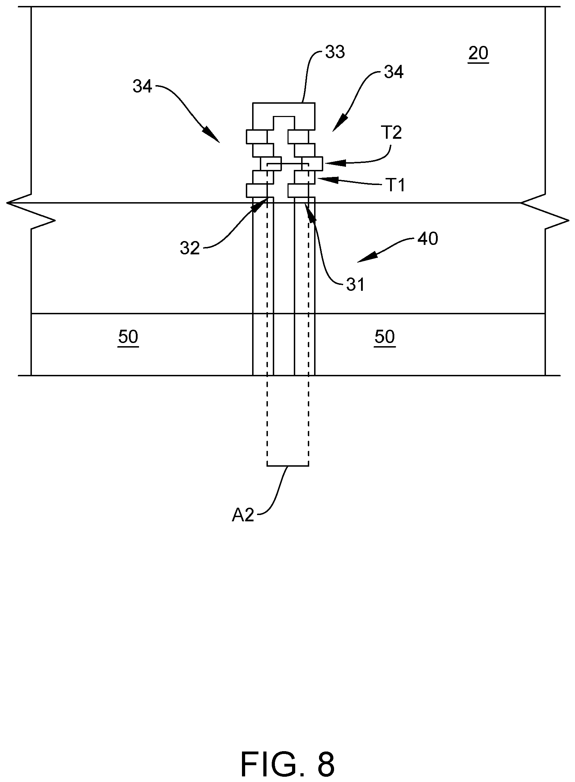

In den **Figuren 4 bis 6** sind jeweils nur die metallische Kühlstruktur 20 und die Verteilstruktur 40 in perspektivischen Darstellungen und in den Figuren 7 und 8 in zwei verschiedenen Seitenansichten dargestellt. Dabei sind in den Figuren - statt der gesamten Kühlstruktur 20 - die mehreren Fluidkanäle 30 der Kühlstruktur 20 dargestellt. Mit anderen Worten: Hier sind die Fluidkanäle 30 ohne den metallischen Körper dargestellt, in den sie eingelassen sind. In Stapelrichtung S gesehen schließt ferner an der Unterseite der Verteilstruktur 40 eine Zuführstruktur 50 an. Demnach ist in Stapelrichtung S gesehen, die Verteilstruktur zwischen der Kühlstruktur und der Zuführstruktur angeordnet. Solch eine Zuführstruktur 50 ist vorzugsweise dazu vorgesehen, eine erste Hauptströmungsrichtung HS1 vorzugeben. Beispielsweise ist die Zuführstruktur kanalförmig ausgebildet. Ferner umfasst die Zuführstruktur 50 mindestens einen Einlass und einen Auslass (hier nicht dargestellt) an die ein Fluidkreislauf angeschlossen werden kann bzw. eine Kühlfluidversorgung und eine Kühlfluidentsorgung. Die Verteilstruktur 40 ist dabei vorzugsweise derart ausgestaltet, dass sie das Fluid aus einem entlang der ersten Hauptströmungsrichtung HS1 fließende Strom heraus in die Kühlstruktur 20 umlenkt bzw. dort einleitet. Weiterhin zeigen die Figuren der Übersicht halber lediglich ein einzelne Reihe Fluidkanälen 30. Bevorzugt ist es vorgesehen, dass mehrere Reihen in einer senkrecht zur Reihenrichtung RR und parallel zur Haupterstreckungsebene HSE verlaufenden Richtung nebeneinander bzw. hintereinander angeordnet sind und jede dieser Reihen wird über eine entsprechende Verteilstruktur 40, beispielswiese eine einzelne Verteilstruktur, mit dem Fluid versorgt. Vorzugsweise erstrecken sich diese mehrere Reihen vollständig über die der Verteilstruktur zugewandten Außenseite A der Kühlstruktur 20.

Insbesondere ist es vorgesehen, dass mehrere Fluidkanäle 30 nebeneinander angeordnet sind. Insbesondere sind in der dargestellten Ausführungsform die Fluidkanäle 30 entlang einer Reihe angeordnet, die im dargestellten Ausführungsbeispiel im Wesentlichen senkrecht zur ersten Hauptströmungsrichtung HS1 verläuft. Grundsätzlich ist es auch vorstellbar, dass die Reihe entlang einer Reihenrichtung RR verläuft, die gegenüber der ersten Hauptströmungsrichtung HS1 um einen Winkel zwischen 0 und 90° geneigt ist. Vorzugsweise ist der Winkel kleiner 45°.

In dem in den **Figuren 4 bis 8** dargestellten Ausführungsbeispiel ist es vorgesehen, dass die Verteilstruktur 40 das Fluid so umlenkt, dass zumindest ein Teil des Fluid zunächst von einer ersten Hauptströmungsrichtung HS1 in eine parallel zur Reihenrichtung verlaufende Querrichtung Q umgelenkt wird, bevor es in die Eingangsöffnungen 31 geleitet wird. Zusätzlich wird das Fluid in Richtung der Eingangsöffnung 31 in Richtung der Kühlstruktur 20, d. h. nach oben, umgelenkt. Dadurch kann die Verteilstruktur mehrere Eingangsöffnungen 31 verschiedener Fluidkanäle 30 mit einem gleichtemperierten Fluid versorgen. Hierzu ist der einleitende Teil 41 als wandartige Struktur ausgebildet, die im dargestellten Ausführungsbeispiel im Wesentlichen parallel zur Reihenrichtung RR verläuft. Bevorzugt ist es vorgesehen, dass die Zuführstruktur 50 das Fluid nur einem Teil der Verteilstruktur 40 zuführt. Im dargestellten Ausführungsbeispiel wird entlang der ersten Hauptströmungsrichtung HS1 gesehen im Wesentlichen ein erster Teil, insbesondere eine linke Hälfte, des einleitenden Teils 41 durch das Kühlfluid angeströmt. Mittels der Verteilstruktur 40 wird aber die vollständige Reihe von Fluidkanälen 30 mit dem Fluid versorgt. Vorzugsweise umfasst der einleitenden Teil eine rampenartige Struktur, die in Reihenrichtung RR gesehen geneigt ist, insbesondere gegenüber der Haupterstreckungsebene HSE geneigt ist.

Nach dem Durchtritt durch die Fluidkanäle 30 verlässt das Fluid die Kühlstruktur 20 über die Ausgangsöffnungen 32 und wird in den ausleitenden Teil 42 der Verteilstruktur geführt. Der ausleitende Teil 42 der Verteilstruktur 40 ist ebenfalls als wandartige Struktur ausgestaltet, die im Wesentlichen parallel zur Reihenrichtung RR verläuft. Insbesondere ist es vorgesehen, dass der ausleitenden Teil 42 so gestaltet ist, dass er das aus den Ausgangsöffnungen tretenden Fluid sammelt und in eine zweite Hauptströmungsrichtung HS2 zurück in die Zuführstruktur 50 umlenkt. Beispielsweise umfasst der ausleitende Teil 42 eine rampenartige Struktur die in Reihenrichtung RR geneigt ist, insbesondere entgegengesetzt geneigt zur rampenartigen Struktur im einleitenden Teil 41 der Verteilstruktur 40. Ferner ist es vorgesehen, dass die erste Hauptströmungsrichtung HS1 und die zweite Hauptströmungsrichtung HS2 parallel zueinander versetzt sind. Mit anderen Worten: Nach dem Verlassen der Verteilstruktur 40 ist die Strömung des Fluid seitlich bzw. lateral versetzt gegenüber der Strömung beim Anströmen der Verteilstruktur 40.

In der dargestellten Ausführungsform ist der einleitenden Teil 41 der Verteilstruktur 40 entlang der ersten Hauptströmungsrichtung HS1 gesehen vor dem ausleitenden Teil 42 der Verteilstruktur 40 angeordnet. Es ist aber auch vorstellbar, dass der ausleitende Teil 42 entlang der ersten Hauptströmungsrichtung HS1 gesehen vor dem einleitenden Teil 31 der Verteilstruktur 40 angeordnet ist.

Die einzelnen Fluidkanäle 30 sind bevorzugt U-Förmig gestaltet, wobei der U-förmig gestaltete Fluidkanal 30 zwei im Wesentlichen senkrecht zur Haupterstreckungsebene HSE verlaufende Schenkelbereiche 34 und einen die beiden Schenkelbereiche 34 verbindenden Querbereich 33 aufweist. Insbesondere dient der Querbereich 33 dem Umlenken des Fluid und ist im verbauten Zustand der Sekundärschicht 13 bzw. der Keramikschicht 11 am nächsten. Vorzugsweise nimmt eine Distanz zwischen dem Querbereich 33 und einer an die Kühlstruktur 20 angrenzende Keramikschicht 11 bzw. Sekundärschicht 13 einen Wert zwischen 0,2 und 1,5 mm, bevorzugt zwischen 0,4 und 1 und besonders bevorzugt zwischen 0,6 mm und 0,8 mm an. Vorzugsweise sind die Fluidkanäle 30, insbesondere deren Schenkelbereiche 34 so gestaltet, dass das Fluid innerhalb der Fluidkanäle 30 verwirbelt wird. Hierzu ist es beispielsweise vorgesehen, dass sich ein parallel zur Haupterstreckungsebene HSE verlaufender Öffnungsquerschnitt Q1, Q2 der Schenkelbereiche 34 entlang einer Strömungsrichtung des Fluid innerhalb des Fluidkanals 30, insbesondere innerhalb des Schenkelbereichs 34, seitlich verlagert. Dabei umfasst der Schenkelbereich 34 einen ersten Teilabschnitt T1 mit einem ersten Öffnungsquerschnitt Q1 und einen zweiten Teilabschnitt T2 mit einem zweiten Öffnungsquerschnitt Q2, wobei der erste Öffnungsquerschnitt Q1 zum zweiten Öffnungsquerschnitt Q2 in einer parallel zur Haupterstreckungsebene HSE verlaufenden Richtung gesehen um einen Versatzabstand V versetzt ist. Vorzugsweise sind der ersten Öffnungsquerschnitt Q1 und der zweite Öffnungsquerschnitt Q2 gleich groß. Es ist aber auch vorstellbar, dass sich der erste Öffnungsquerschnitt vom zweiten Öffnungsquerschnitt unterscheidet. Insbesondere sind der erste Teilabschnitt T1 und der zweite Teilabschnitt T2 jeweils Metalllagen zugeordnet, die beispielsweise bei der Fertigung übereinandergestapelt werden. Dabei können die einzelnen Metalllagen gleich dick sein oder sich bezüglich ihrer Dicke unterscheiden. Es ist beispielsweise auch vorstellbar, dass die Dicke der einzelnen Ebenen in Richtung der Bauteilseite ab- und/oder zunimmt.

Insbesondere ist es vorgesehen, dass der erste Öffnungsquerschnitt Q1 und der zweite Öffnungsquerschnitt Q2 in einer parallel zur ersten Hauptströmungsrichtung HS1 bzw. zweiten Hauptströmungsrichtung HS2 und einer parallel zur Reihenrichtung RR, d. h. in zwei zueinander nicht parallel verlaufenden Richtungen, zueinander versetzt sind. Vorzugsweise nimmt ein Verhältnis eines Überlappbereichs, in dem der ersten Öffnungsquerschnitt Q1 und der zweite Öffnungsquerschnitt Q2 in Stapelrichtung S gesehen übereinander angeordnet sind, und dem ersten Öffnungsquerschnitt Q1 bzw. dem zweiten Öffnungsquerschnitt Q2 einen Wert zwischen 0,5 und 0,9, bevorzugt zwischen 0,5 und 0,8 und besonders bevorzugt zwischen 0,5 und 0,7 an. Vorstellbar ist insbesondere dass der Öffnungsquerschnitt der Eingangsöffnung und/oder der Ausgangsöffnung größer ist als der erste Öffnungsquerschnitt und/oder der zweite Öffnungsquerschnitt. Dadurch lässt sich ein trichterartiger Eingangsbereich und Ausgansbereich für den Fluidkanal bilden.

Es ist aber auch vorstellbar, dass der erste Öffnungsquerschnitt Q1 und der zweite Öffnungsquerschnitt Q2 unterschiedlich groß sind. Bevorzugst sind erste und zweite Öffnungsquerschnitte derart ausgestaltet, dass sie einen im Wesentlichen spiralförmigen Verlauf für den Fluidkanal 30 bilden. Die Fluidkanäle 30 lassen sich beispielsweise durch ein Aufeinanderschichten von Metallschichten, d. h. zumindest einer ersten Metallschicht 11 und einer zweiten Metallschicht 12, mit entsprechenden Öffnungen oder durch ein 3D Druckverfahren realisieren. Weiterhin ist es vorgesehen, dass die Eingangsöffnung 13 einen ersten Öffnungsquerschnitt aufweist, dessen Durchmesser und/oder Kantenlänge einen Wert zwischen 0,1 mm und 2,5 mm, bevorzugt zwischen 0,5 mm und 1,5 mm und bevorzugt im Wesentlichen von 1 mm aufweist. Dabei ist es bevorzugt vorgesehen, dass sich der erste Öffnungsquerschnitt Q1 bzw. der zweite Öffnungsquerschnitt Q2 innerhalb der Schenkelbereiche 34 des Fluidkanals 30 nicht ändern.

Weiterhin ist es vorgesehen, dass ein weitere Abstand A2 zwischen zweier benachbarter Schenkelbereiche, bevorzugt desselben Fluidkanals, einen Wert zwischen 0,1 mm und 5 mm, bevorzugt zwischen 0,2 mm und 2 mm und besonders bevorzugt im Wesentlichen 1,5 mm annimmt. Dabei wird der weitere Abstand A2 zwischen zwei Mitten der ersten Querschnittsöffnung Q1 bzw. zweiten Querschnittsöffnungen Q2 auf derselben Höhe in Stapelrichtung S gesehen gemessen.

Neben den oben beschriebenen Kühlkörpern 20 bzw. Trägersubstraten 1 sind auch weitere Kühlkörper 20 mit unterschiedlichen Geometrien vorstellbar. Beispielsweise ist sogar denkbar, dass der Kühlkörper 20 aus einem im Wesentlichen flachen, unstrukturierten Metallkörper 20 gebildet wird. Bevorzugt ist allerdings ein strukturierter Kühlkörper 20, der beispielsweise zu seiner Kühlseite offen und/oder zumindest teilweise geschlossen oder vollständig geschlossen ist. Vorzugsweise bilden sich Mikrokanäle im gefertigten Kühlkörper 20 aus, durch die dann im Betrieb ein Kühlfluid, vorzugsweise eine Kühlflüssigkeit, geführt werden kann. Dadurch lässt sich die entstandene Wärme, beispielsweise auf der Bauteilseite 4 oder hervorgerufen durch eine Laserdiode, die an die Anschlussfläche 30 montiert ist, abführen. Um zu verhindern, dass mit der Zeit der aus einem Metall gefertigte Kühlkörper 20 korrodiert, ist es vorgesehen, dass der Kühlkörper 20 zumindest teilweise eine Korrosionsschutzschicht 30 aufweist. Andernfalls würde eine entsprechende Korrosion dazu führen, dass der Kühlkörper 20 entweder undicht wird und/oder die Mikrokanäle bzw. Kühlbereiche verstopfen.
- 1: Trägerelement
- 4: elektrisches Bauteil
- 5: Bauteilseite
- 6: Kühlseite
- 7: stegartiges Element
- 11: erste Metallschicht
- 12: zweite Metallschicht
- 13: dritte Metallschicht
- 14: untere Deckschicht
- 15: obere Deckschicht
- 21: erster Teil
- 22: zweiter Teil
- 24: weitere Ausnehmung
- 25: Finnenstruktur
- 30: Anschlussfläche
- 33: Querbereich
- 34: Schenkelbereich
- 40: Verteilstruktur
- 41: einleitender Teil
- 42: ableitender Teil
- 50: Zuführstruktur
- 70: Metall-Keramik-Substrat
- 71: Keramikelement
- 72: Bauteilmetallisierung
- 75: Zwischenschicht
- 73: Sekundärschicht
- A1: Abstand
- A2: weiterer Abstand
- S: Stapelrichtung
- T1: erster Teilabschnitt
- T2: zweiter Teilabschnitt
- Q: Querrichtung
- Q1: erste Querschnittsöffnung
- Q2: zweite Querschnittsöffnung
- M: Mittelachse
- D: Dicke
- V: Versatzabstand
- RR: Reihenrichtung
- HS1: erste Hauptströmungsrichtung
- HS2: zweite Hauptströmungsrichtung
- HSE: Haupterstreckungsebene

## Patentansprüche

1. Trägersubstrat (1) für elektrische Bauteile (4), umfassend:
- einen Kühlkörper (20), und
- ein Keramikelement (71), wobei das Keramikelement (71) zumindest abschnittsweise an den Kühlkörper (20) angebunden ist,
wobei im gefertigten Trägersubstrat (1) eine lotmaterialfreie Bindungsschicht zwischen dem Kühlkörper (20) und dem Keramikelement (71) ausgebildet ist, und
wobei eine Haftvermittlerschicht der Bindungsschicht einen Flächenwiderstand aufweist, der größer ist als 5 Ohm/sq, bevorzugt größer als 10 Ohm/sq und besonders bevorzugt größer als 20 Ohm/sq, wobei der Kühlkörper (20) über eine Rückseitenmetallisierung (74) an das Keramikelement (71) angebunden ist und die Haftvermittlerschicht zwischen Rückseitenmetallisierung (74) und Keramikelement (71) ausgebildet ist.

2. Trägersubstrat (1) gemäß Anspruch 1, wobei das Keramikelement (71) eine nicht über ein Direktanbindungsverfahren anbindbare Materialzusammensetzung aufweist umfasst.

3. Trägersubstrat (1) gemäß einem der vorhergehenden Ansprüche, wobei das Keramikelement Si₃N₄ umfasst.

4. Trägersubstrat (1) gemäß einem der vorhergehenden Ansprüche, wobei sich eine Körnung in der Rückseitenmetallisierung (74) von einer Körnung im Kühlkörper (20) unterscheidet.

5. Trägersubstrat (1) gemäß einem der vorhergehenden Ansprüche, wobei das Keramikelement eine Dicke aufweist, die kleiner ist als 300 µm, bevorzugt kleiner als 250 µm und besonders bevorzugt kleiner als 200 µm.

6. Trägersubstrat (1) gemäß einem der vorhergehenden Ansprüche, wobei der Kühlkörper mindestens aus einer ersten Metallschicht (21) und einer zweiten Metallschicht (22) ausgebildet ist, die übereinander mittels eines Direktanbindungsverfahren, insbesondere ein lotfreies Direktanbindungsverfahren, verbunden sind, wobei die erste Metallschicht (21) und/oder die zweite Metallschicht (22) Aussparungen aufweisen, die im gefertigten Trägersubstrat (1) einen Kühlkanal formen.

7. Trägersubstrat (1) gemäß einem der vorhergehenden Ansprüche, eine in Stapelrichtung (S) bemessene Dicke der Bindungsschicht oder Haftvermittlerschicht, gemittelt über mehrere Messpunkte innerhalb einer vorbestimmten Fläche oder in mehreren Flächen, die parallel zur Haupterstreckungsebene verläuft oder verlaufen, einen Wert annimmt, der kleiner als 1000 nm, bevorzugt kleiner als 600 nm und besonders bevorzugt kleiner als 350 nm ist.

8. Verfahren zur Herstellung eines Trägersubstrat (1) gemäß einem der vorhergehenden Ansprüche, umfassend:
- Anbinden einer Rückseitenmetallisierung (74) und vorzugsweise einer Bauteilmetallisierung (72) an ein Keramikelement (71) mittels heißisostatischen Pressen zur Ausbildung eines Metall-Keramik-Substrats,
- Bereitstellen eines Kühlkörpers (20), insbesondere eines Kühlkörpers (20) mit einer Kühlkanalstruktur, und
- Anbinden des Kühlkörpers (20) an die Rückseitenmetallisierung (74) mittels eines Direktanbindungsverfahrens, insbesondere eines DCB (Direct copper bonding)-Verfahren.

9. Verfahren gemäß einem der vorhergehenden Ansprüche, wobei eine Ausnehmung in einer ersten Metallschicht (21) und/oder der zweiten Metallschicht (22) mittels Ätzen, Erodieren und/oder Fräsen realisiert wird und mindestens die erste Metallschicht (21) und die zweite Metallschicht (22) zur Bildung des Kühlkörpers (20) miteinander mittels eines DCB-Verfahrens verbunden werden, wobei die Anbindung der mindestens ersten Metallschicht (21) und/oder zweiten Metallschicht (22) an die Rückseitenmetallisierung und die Anbindung der ersten Metallschicht (21) und der zweiten Metallschicht (22) zur Bildung des Kühlkörpers (20) zumindest teilweise zeitgleich durchgeführt wird.

10. Verfahren gemäß einem der vorhergehenden Ansprüche, wobei eine Aktivmetallschicht zur Bildung der Bindungsschicht zwischen dem Keramikelement (71) einerseits und der Bauteilmetallisierung (72) und/oder der Rückseitenmetallisierung (74) anderseits angeordnet wird.

11. Verfahren gemäß Anspruch 10, wobei ein Verhältnis zwischen einer Dicke der Aktivmetallschicht zu einer Dicke der ersten Metallschicht (21) und/oder zweiten Metallschicht (22) einen Wert zwischen 0,0001 und 0,005, annimmt.

12. Verfahren gemäß einem der vorhergehenden Ansprüche, wobei das Metall-Keramik-Substrat (70) durch heißisostatisches Pressen erzeugt wird und danach das Anbinden des Kühlkörpers (20) an die Rückseitenmetallisierung (74) realisiert wird.

## Claims

1. A carrier substrate (1) for electrical components (4), comprising:
- a heat sink (20), and
- a ceramic element (71), wherein the ceramic element (71) is bonded to the heat sink (20) at least in sections,
wherein a bonding layer free of solder material is formed in the manufactured carrier substrate (1) between the heat sink (20) and the ceramic element (71), and wherein an adhesion agent layer of the bonding layer has a sheet resistance which is greater than 5 ohm/sq, more preferably greater than 10 ohm/sq and most preferably greater than 20 ohm/sq, wherein the heat sink (20) is bonded to the ceramic element (71) via a backside metallization (74) and the adhesion agent layer is formed between the backside metallization (74) and the ceramic element (71).

2. The carrier substrate (1) according to claim 1, wherein the ceramic element (71) comprises a material composition which cannot be bonded via a direct bonding method.

3. The carrier substrate (1) according to any one of the preceding claims, wherein the ceramic element comprises Si₃N₄.

4. The carrier substrate (1) according to any one of the preceding claims, wherein a grain size in the backside metallization (74) is different from a grain size in the heat sink (20).

5. The carrier substrate (1) according to any one of the preceding claims, wherein the ceramic element has a thickness which is less than 300 µm, more preferably less than 250 µm and most preferably less than 200 µm.

6. The carrier substrate (1) according to any one of the preceding claims, wherein the heat sink is formed from at least a first metal layer (21) and a second metal layer (22) which are joined on top of one another by means of a direct bonding method, in particular a solderless direct bonding method, wherein the first metal layer (21) and/or the second metal layer (22) have recesses which form a cooling channel in the manufactured carrier substrate (1).

7. The carrier substrate (1) according to any one of the preceding claims, a thickness of the bonding layer or adhesion agent layer, measured in the stacking direction (S), averaged over a plurality of measuring points within a predetermined area or in a plurality of areas which course or run parallel to the main extension plane, has a value which is less than 1000 nm, more preferably less than 600 nm and most preferably less than 350 nm.

8. The method of manufacturing a carrier substrate (1) according to any one of the preceding claims, comprising:
- bonding a backside metallization (74) and preferably a component metallization (72) to a ceramic element (71) by means of hot isostatic pressing for forming a metal-ceramic substrate,
- providing a heat sink (20), in particular a heat sink (20) with a cooling channel structure, and
- bonding the heat sink (20) to the backside metallization (74) by means of a direct bonding method, in particular a DCB (direct copper bonding) method.

9. The method according to any one of the preceding claims, wherein a void in a first metal layer (21) and/or the second metal layer (22) is realized by means of etching, eroding and/or milling and at least the first metal layer (21) and the second metal layer (22) are joined together by means of a DCB process to form the heat sink (20), wherein the bonding of the at least first metal layer (21) and/or second metal layer (22) to the backside metallization and the bonding of the first metal layer (21) and the second metal layer (22) to form the heat sink (20) are performed at least partially simultaneously.

10. The method according to any one of the preceding claims, wherein an active metal layer for forming the bonding layer is arranged between the ceramic element (71) on the one hand and the component metallization (72) and/or the backside metallization (74) on the other hand.

11. The method according to claim 10, wherein a ratio between a thickness of the active metal layer and a thickness of the first metal layer (21) and/or second metal layer (22) has a value between 0.0001 and 0.005.

12. The method according to any one of the preceding claims, wherein the metal-ceramic substrate (70) is produced by hot isostatic pressing and thereafter the bonding of the heat sink (20) to the backside metallization (74) is realized.

## Revendications

1. Substrat de support (1) pour composants électriques (4), comprenant :
- un dissipateur thermique (20), et
- un élément céramique (71), l'élément céramique (71) étant relié au moins localement au dissipateur thermique (20),
une couche de liaison exempte de matériau d'apport de brasage étant formée entre le dissipateur thermique (20) et l'élément céramique (71) dans le substrat de support (1) fabriqué, et
une couche d'agent adhésif de la couche de liaison présentant une résistance superficielle supérieure à 5 ohms/carré, de préférence supérieure à 10 ohms/carré et de manière particulièrement préférée supérieure à 20 ohms/carré,
le dissipateur thermique (20) étant relié à l'élément céramique (71) par l'intermédiaire d'une métallisation de face arrière (74), et la couche d'agent adhésif étant formée entre la métallisation de face arrière (74) et l'élément céramique (71).

2. Substrat de support (1) selon la revendication 1,
dans lequel l'élément céramique (71) contient une composition de matériau qui ne peut pas être reliée par un procédé de liaison directe.

3. Substrat de support (1) selon l'une des revendications précédentes,
dans lequel l'élément céramique contient du Si₃N₄.

4. Substrat de support (1) selon l'une des revendications précédentes,
dans lequel la granulométrie de la métallisation de face arrière (74) diffère de la granulométrie du dissipateur thermique (20).

5. Substrat de support (1) selon l'une des revendications précédentes,
dans lequel l'élément céramique présente une épaisseur inférieure à 300 µm, de préférence inférieure à 250 µm et de manière particulièrement préférée inférieure à 200 µm.

6. Substrat de support (1) selon l'une des revendications précédentes,
dans lequel le dissipateur thermique est constitué d'au moins une première couche métallique (21) et d'une deuxième couche métallique (22) qui sont reliées l'une à l'autre par un procédé de liaison directe, en particulier par un procédé de liaison directe exempt d'apport de brasage, la première couche métallique (21) et/ou la deuxième couche métallique (22) présentant des évidements qui forment un canal de refroidissement dans le substrat de support (1) fabriqué.

7. Substrat de support (1) selon l'une des revendications précédentes,
dans lequel une épaisseur de la couche de liaison ou de la couche d'agent adhésif, mesurée dans la direction d'empilement (S), moyennée sur plusieurs points de mesure à l'intérieur d'une surface prédéterminée ou dans plusieurs surfaces qui s'étend(ent) parallèlement au plan d'extension principale, prend une valeur inférieure à 1000 nm, de préférence inférieure à 600 nm et de manière particulièrement préférée inférieure à 350 nm.

8. Procédé de fabrication d'un substrat de support (1) selon l'une des revendications précédentes, consistant à :
- relier une métallisation de face arrière (74) et de préférence une métallisation de composant (72) à un élément céramique (71) au moyen d'un pressage isostatique à chaud pour former un substrat métal-céramique,
- fournir un dissipateur thermique (20), en particulier un dissipateur thermique (20) avec une structure à canal de refroidissement, et
- relier le dissipateur thermique (20) à la métallisation de face arrière (74) par un procédé de liaison directe, en particulier par un procédé DCB (Direct Copper Bonding).

9. Procédé selon l'une des revendications précédentes,
dans lequel un évidement est réalisé dans une première couche métallique (21) et/ou dans une deuxième couche métallique (22) par attaque chimique, par érosion et/ou par fraisage, et au moins la première couche métallique (21) et la deuxième couche métallique (22) sont reliées entre elles par un procédé DCB (Direct Copper Bonding) pour former le dissipateur thermique (20), la liaison au moins de la première couche métallique (21) et/ou de la deuxième couche métallique (22) à la métallisation de face arrière et la liaison de la première couche métallique (21) et de la deuxième couche métallique (22) pour former le dissipateur thermique (20) étant réalisées au moins en partie simultanément.

10. Procédé selon l'une des revendications précédentes,
dans lequel une couche de métal actif destinée à former la couche de liaison est disposée entre l'élément céramique (71) d'une part et la métallisation de composant (72) et/ou la métallisation de face arrière (74) d'autre part.

11. Procédé selon la revendication 10,
dans lequel le rapport entre l'épaisseur de la couche de métal actif et l'épaisseur de la première couche métallique (21) et/ou la deuxième couche métallique (22) prend une valeur comprise entre 0,0001 et 0,005.

12. Procédé selon l'une des revendications précédentes,
dans lequel le substrat métal-céramique (70) est produit par pressage isostatique à chaud, puis la liaison du dissipateur thermique (20) à la métallisation de face arrière (74) est réalisée.
